# EUROPEAN PATENT APPLICATION

(11) **EP 4 412 424 A1**
(43) Date of publication of application: **07.08.2024**
(21) Application number: 23205875.0
(22) Date of filing: 25.10.2023
(51) Int. Cl.: H10B 53/50, H10B 53/30

(54) **SEMICONDUCTOR DEVICES AND METHODS OF MANUFACTURING THE SAME**

(30) Priority: 03.02.2023 KR 20230014869
(71) Applicant: Samsung Electronics Co., Ltd., Suwon-si, Gyeonggi-do 16677 (KR)
(72) Inventor: LEE, Kiseok, 16677 Suwon-si (KR); HAN, Jinwoo, 16677 Suwon-si (KR); LIM, Hanjin, 16677 Suwon-si (KR)
(74) Representative: Marks & Clerk LLP

(57) **Abstract**

A semiconductor device includes a gate structure (170), a bit line structure (355), a contact plug structure (430, 450, 485), a stack structure (600, 610), and a capacitor (640, 650, 660). The gate structure (170) is disposed on first substrate (100). The bit line structure (355) is disposed on the gate structure (170). The contact plug structure (430, 450, 485) is disposed on the first substrate (100) and spaced apart from the bit line structure (355). The stack structure (600, 610) is disposed on the bit line structure (355) and the contact plug structure (430, 450, 485), and may include insulation layers (600) and plate electrodes (610) alternately stacked in a vertical direction substantially perpendicular to an upper surface of the first substrate (100). The capacitor (640, 650, 660) includes a second electrode (660) extending through the stack structure and contacting the contact plug structure (430, 450, 485). A ferroelectric pattern (650) is disposed on a sidewall of the second electrode (660). First electrodes (640) are disposed on a sidewall of the ferroelectric pattern (650), contact sidewalls of the plate electrodes (610), respectively, and are spaced apart from each other in the vertical direction.

## Description

### BACKGROUND

### 1. Field

Embodiments relate to a semiconductor device and a method of manufacturing the same.

### 2. Description of the Related Art

A DRAM device includes gate structures, each of which extends through upper portions of active patterns in a first direction, bit line structures extending in a second direction on central portions of the active patterns, contact plug structures on opposite end portions of the active patterns, respectively, and capacitors disposed on the contact plug structures, respectively.

In a DRAM device, a memory capacity depends on an area of each of the capacitors and a permittivity of a dielectric layer included in each of the capacitors. As such, a new method for increasing the memory capacity of a semiconductor device is desired.

### SUMMARY

Embodiments are directed to a semiconductor device including a gate structure on a first substrate; a bit line structure on the gate structure; a contact plug structure on the first substrate, the contact plug being spaced apart from the bit line structure; a stack structure on the bit line structure and the contact plug structure, the stack structure including insulation layers and plate electrodes alternately stacked in a vertical direction substantially perpendicular to an upper surface of the first substrate, a capacitor including a second electrode extending through the stack structure and contacting the contact plug structure, a ferroelectric pattern on a sidewall of the second electrode; and first electrodes on a sidewall of the ferroelectric pattern, the first electrodes contacting sidewalls of the plate electrodes, respectively, and being spaced apart from each other in the vertical direction. Embodiments may also be directed to a semiconductor device including a gate structure on a first substrate, the gate structure extending in a first direction substantially parallel to an upper surface of the first substrate, a bit line structure on the gate structure, a contact plug structure on the first substrate, the contact plug being spaced apart from the bit line structure, a stack structure on the bit line structure and the contact plug structure, the stack structure including insulation layers and plate electrodes alternately stacked in a vertical direction substantially perpendicular to an upper surface of the first substrate; and a capacitor including a second electrode extending through the stack structure and contacting the contact plug structure, a ferroelectric pattern on a sidewall of the second electrode; and a first electrode on a sidewall of the ferroelectric pattern, the first electrode contacting a sidewall of each of the plate electrodes, wherein an edge portion of the stack structure in the first direction has a staircase shape.

Embodiments may also be directed to a semiconductor device including active patterns on a first substrate, an isolation structure on the first substrate, the isolation structure covering sidewalls of the active patterns, gate structures extending through upper portions of the active patterns and the isolation structure, each of the gate structures extending in a first direction substantially parallel to an upper surface of the first substrate, and the gate structures being spaced apart from each other in a second direction, which is substantially parallel to the upper surface of the first substrate and intersects the first direction, bit line structures on the active patterns and the isolation structure, each of the bit line structures extending in the second direction, and the bit line structures being spaced apart from each other in the first direction, contact plug structures contacting upper surfaces of the active patterns, respectively, a stack structure on the bit line structures and the contact plug structures, the stack structure including insulation layers and plate electrodes alternately stacked in a vertical direction substantially perpendicular to the upper surface of the first substrate, and a capacitor including, a second electrode extending through the stack structure and contacting each of the contact plug structures, a ferroelectric pattern on a sidewall of the second electrode, and first electrodes on sidewalls of the ferroelectric pattern, the first electrodes contacting sidewalls of the plate electrodes, respectively, and being spaced apart from each other in the vertical direction.

At least some of the above and other features of the invention are set out in the claims.

### BRIEF DESCRIPTION OF THE DRAWINGS

Features will become apparent to those of skill in the art by describing in detail embodiments with reference to the attached drawings in which:
FIGS. 1 to 6 are plan views and cross-sectional views illustrating a semiconductor device in accordance with example embodiments.
FIGS. 7 to 37 are plan views and cross-sectional views illustrating a method of manufacturing a semiconductor device in accordance with example embodiments.
FIG. 38 is cross-sectional view illustrating a semiconductor device in accordance with example embodiments.
FIGS. 39 to 41 are a plan view and cross-sectional views illustrating a semiconductor device in accordance with example embodiments.

### DETAILED DESCRIPTION

The above and other aspects and features of the capacitor structures and the methods of manufacturing the same, the semiconductor devices including the capacitor structures, and the methods of manufacturing the same in accordance with example embodiments will become readily understood from detail descriptions that follow, with reference to the accompanying drawings. It will be understood that, although the terms "first," "second," and/or "third" may be used herein to describe various materials, layers, regions, pads, electrodes, patterns, structure and/or processes, these various materials, layers, regions, pads, electrodes, patterns, structure and/or processes should not be limited by these terms. These terms are only used to distinguish one material, layer, region, pad, electrode, pattern, structure or process from another material, layer, region, pad, electrode, pattern, structure or process. Thus, "first", "second" and/or "third" may be used selectively or interchangeably for each material, layer, region, electrode, pad, pattern, structure or process respectively.

Hereinafter, two directions among horizontal directions that are substantially parallel to an upper surface of a first substrate or a second substrate, which may be substantially orthogonal to each other, may be referred as first and second directions D1 and D2, respectively, and two directions among the horizontal directions that are substantially parallel to the upper surface of the first substrate or the second substrate, which may have an acute angle with respect to each of the first and second directions D1 and D2, which may be substantially orthogonal to each other, may be referred to as third and fourth directions D3 and D4, respectively.

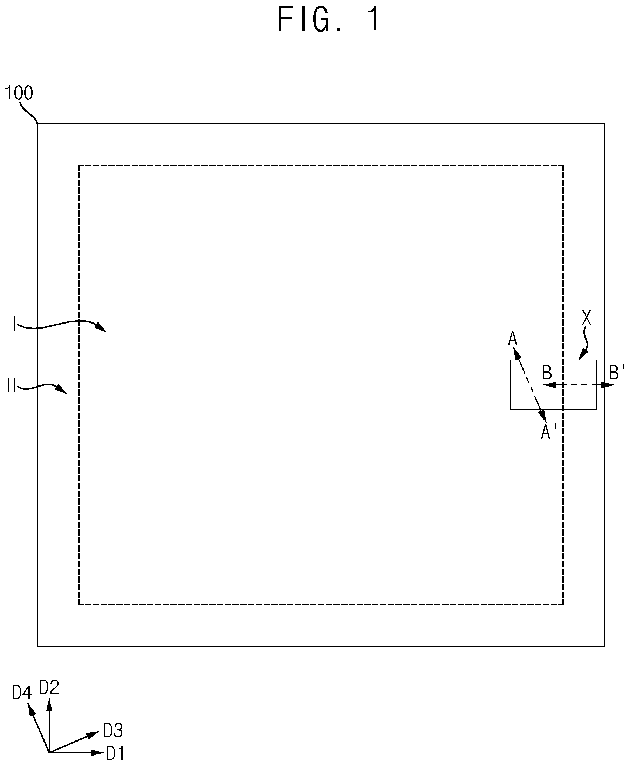

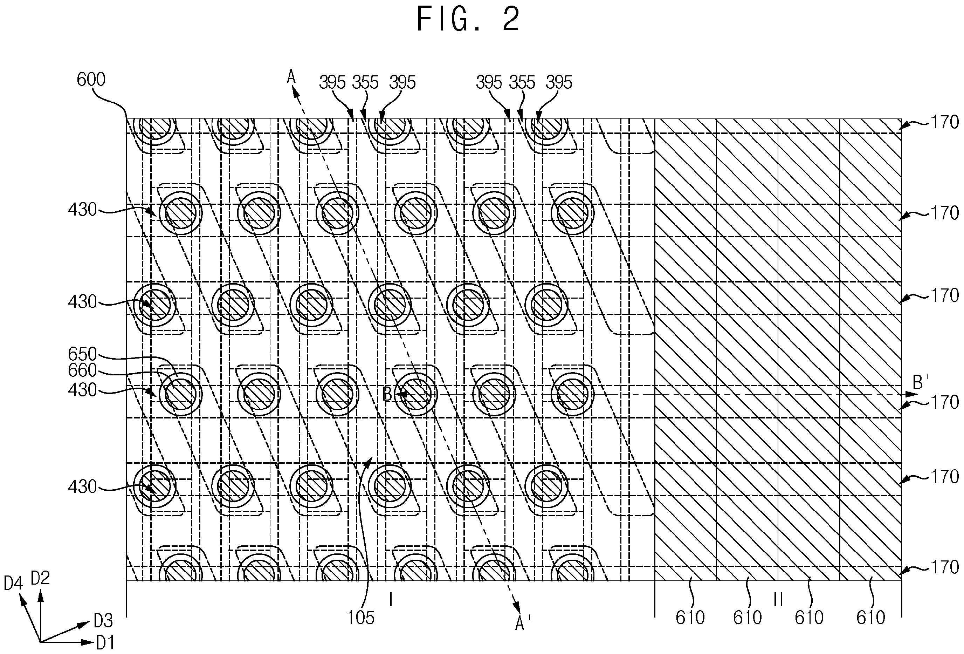

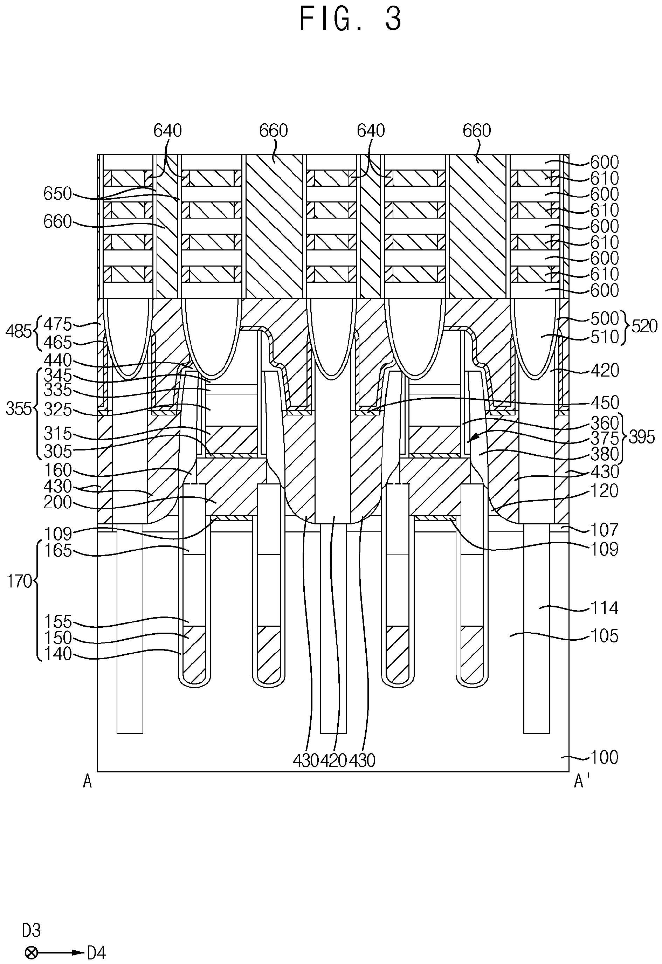

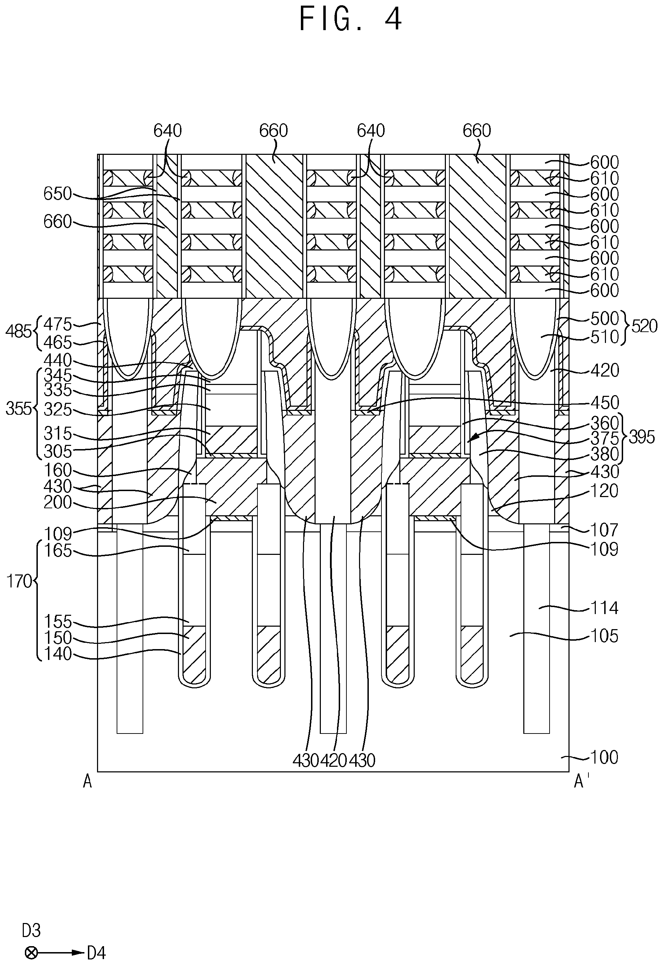

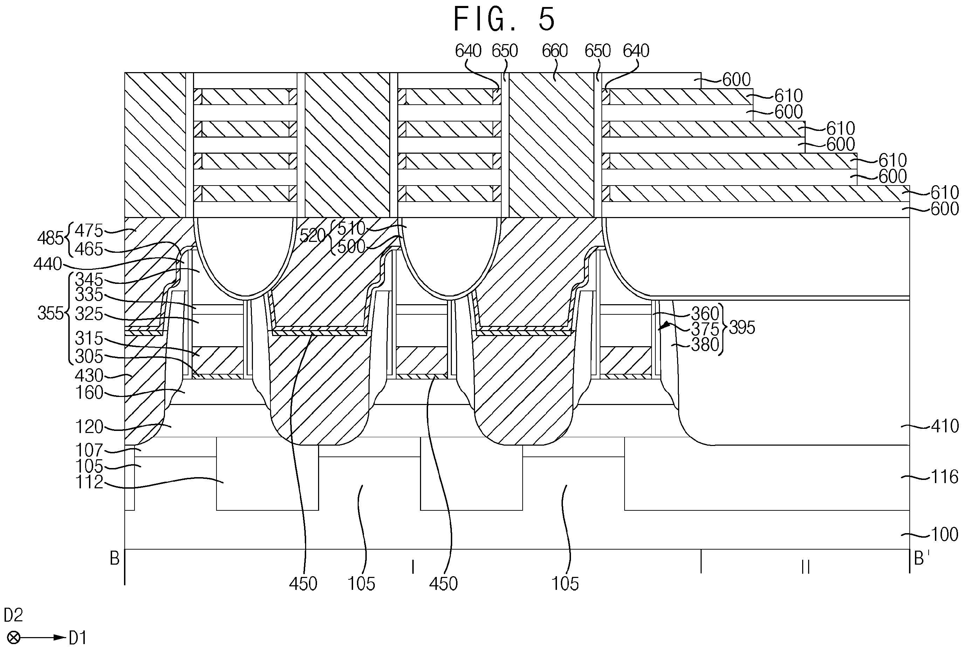

FIGS. 1 to 6 are plan views and cross-sectional views illustrating a semiconductor device in accordance with example embodiments. Specifically, FIGS. 1, 2, and 6 are the plan views, and FIGS. 3 and 4 are cross-sectional views taken along line A-A' of FIG. 2. FIG. 5 is a cross-sectional view taken along line B-B' of FIG. 2. FIGS. 2 to 6 are drawings of region X in FIG. 1.

The semiconductor device may include a first active pattern 105, a gate structure 170, a conductive filling pattern 200, a first bit line structure 355, a contact plug structure, a stack structure, and a capacitor on a first substrate 100.

The semiconductor device may further include an isolation structure, a spacer structure 395, a fourth spacer 440, first and second ohmic contact patterns 109 and 450, a first insulation pattern 410, a fence pattern 420, first and second pads 120 and 160, and a second insulation pattern structure 520.

The first substrate 100 may include silicon, germanium, silicon-germanium, or a III-V group compound semiconductor, e.g., GaP, GaAs, GaSb, etc. In example embodiments, the first substrate 100 may be a silicon-on-insulator (SOI) substrate or a germanium-on-insulator (GOI) substrate.

The first substrate 100 may include a first region I and a second region II surrounding the first region I. In example embodiments, the first region I may be a cell array region in which memory cells may be disposed, and the second region II may be an extension region in which contact plugs for transferring electrical signals to the memory cells may be disposed.

A sidewall of the first active pattern 105 may be covered by the isolation structure on the first substrate 100, and the first active pattern 105 may be defined on the first substrate 100.

The isolation structure may include first, second and third isolation patterns 112, 114 and 116. In example embodiments, the first isolation pattern 112 may extend in the fourth direction D4 on the first region I of the first substrate 100, and a plurality of the first isolation patterns 112 may be spaced apart from each other in the first direction D1. Additionally, the second isolation pattern 114 may extend in the first direction D1 and may be connected to the first isolation patterns 112 disposed in the first direction D1. A plurality of second isolation patterns 114 may be spaced apart from each other in the second direction D2. The third isolation pattern 116 may be disposed on the second region II of the first substrate 100 and may be connected to the second isolation pattern 114.

In example embodiments, the first active pattern 105 may extend in the fourth direction D4 to a certain length, and a plurality of first active patterns 105 may be spaced apart from each other in the fourth direction D4 by the second isolation pattern 114. Additionally, a plurality of first active patterns 105 may be spaced apart from each other in the first direction D1 by the first isolation pattern 112. Thus, ones of the first active patterns 105 disposed in the first direction D1 may be aligned with each other along the first direction D1. In other words, end portions of the ones of the first active patterns 105 disposed in the first direction D1, which may correspond to each other in the fourth direction D4, may be aligned with each other along the first direction D1.

The first active pattern 105 may include a material that is substantially the same as a material of the first substrate 100. Each of the first, second and third isolation patterns 112, 114 and 116 may include, for example, an oxide such as silicon oxide. An impurity region 107 including, for example, n-type impurities or p-type impurities may be formed at an upper portion of the first active pattern 105.

The first pad 120 may be disposed on the first active pattern 105 and the isolation structure on the first region I of the first substrate 100. A plurality of first pads 120 may be spaced apart from each other in the first and second directions D1 and D2. The first pad 120 may include an oxide, e.g., silicon oxide.

The gate structure 170 may extend in the first direction D1 through upper portions of the first active pattern 105 and the isolation structure on the first and second regions I and II of the first substrate 100. The gate structure 170 may serve as a word line. The gate structure 170 may include a first conductive pattern 150, a second conductive pattern 155 and a first capping pattern 165 sequentially stacked in a vertical direction substantially perpendicular to the upper surface of the first substrate 100. Sidewalls of the first conductive pattern 150, the second conductive pattern 155, the first capping pattern 165, and a lower surface of the first conductive pattern 150 may be covered by a gate insulation pattern 140. However, in some implementations, a portion of an upper sidewall of the first capping pattern 165 may not be covered by the gate insulation pattern 140. The first and second conductive patterns 150 and 155 may collectively form a gate electrode.

The gate insulation pattern 140 may include, for example, an oxide such as silicon oxide. The first conductive pattern 150 may include, for example, a metal, a metal nitride, or a metal silicide. The second conductive pattern 155 may include, for example, polysilicon doped with n-type impurities or p-type impurities. The first capping pattern 165 may include, for example, an insulating nitride such as silicon nitride.

In example embodiments, the gate structure 170 may extend in the first direction D1, and a plurality of gate structures 170 may be spaced apart from each other in the second direction D2. Two gate structures 170 spaced apart from each other in the second direction D2 may extend through an upper portion of a first active pattern 105. The first active pattern 105 extending in the fourth direction D4 may include a central portion that is between the two gate structures 170 next to each other in the second direction D2, and end portions each of which may be disposed between a corresponding one of the two gate structures 170 and the second isolation pattern 114.

The second pad 160 may be disposed on the first pad 120 and the gate structure 170 on the first region I of the first substrate 100. A plurality of second pads 160 may be spaced apart from each other in the first and second directions D1 and D2. The second pad 160 may include, for example, an insulating nitride such as silicon nitride.

The conductive filling pattern 200 may be disposed on the first active pattern 105 and the isolation structure on the first region I of the first substrate 100 and may extend through the first and second pads 120 and 160. The conductive filling pattern 200 may be disposed on the central portion of the first active pattern 105.

The first ohmic contact pattern 109 may be disposed between the impurity region 107 at the upper portion of the first active pattern 105 and the conductive filling pattern 200. The first ohmic contact pattern 109 may include, for example, a metal silicide such as titanium silicide, cobalt silicide, nickel silicide, etc.

A plurality of conductive filling patterns 200 may be spaced apart from each other along the first and second directions D1 and D2. In example embodiments, the conductive filling pattern 200 may include a lower portion and an upper portion stacked in the vertical direction. The lower portion may extend through the first pad 120, and the upper portion may extend through the second pad 160.

In example embodiments, the lower portion of the conductive filling pattern 200 may contact sidewalls of two gate structures 170 extending through the upper portion of the first active pattern 105 that face each other in the second direction D2, specifically, sidewalls of the first capping patterns 165 that face each other in the second direction D2.

The conductive filling pattern 200 may include, for example, a metal, a metal nitride, etc.

The first bit line structure 355 may include an adhesive pattern 305, a fourth conductive pattern 315, a second mask 325, an etch stop pattern 335 and a second capping pattern 345 sequentially stacked on the conductive filling pattern 200 and the second pad 160 in the vertical direction. The second mask 325, the etch stop pattern 335 and the second capping pattern 345 may collectively form a first insulation pattern structure.

The adhesive pattern 305 may include, for example, a metal nitride such as titanium nitride or a metal silicon nitride such as titanium silicon nitride. The fourth conductive pattern 315 may include, for example, a metal such as tungsten. Each of the second mask 325, the etch stop pattern 335 and the second capping pattern 345 may include, for example, an insulating nitride such as silicon nitride. In some embodiments, the second mask 325, the etch stop pattern 335 and the second capping pattern 345 may include substantially the same material so as to be merged with each other. Accordingly, the first insulation pattern structure may have a single layer structure.

In example embodiments, the first bit line structure 355 may extend in the second direction D2 on the first region I of the first substrate 100, and a plurality of first bit line structures 355 may be spaced apart from each other in the first direction D1. Each of the first bit line structures 355 may contact an upper surface of the conductive filling pattern 200.

The spacer structure 395 may include a first spacer 360, an air spacer 375 and a third spacer 380 sequentially stacked in the first direction D1 on each of opposite sidewalls of the first bit line structure 355 in the first direction D1.

The first spacer 360 may cover each of opposite sidewalls of the first bit line structure 355 in the first direction D1 and an upper surface of the second pad 160. A cross section in the first direction D1 of the first spacer 360 may have an "L" shape. The air spacer 375 may be on an outer sidewall of the first spacer 360. The third spacer 380 may be on an outer sidewall of the air spacer 375 and a sidewall of the second pad 160.

Each of the first and third spacers 360 and 380 may include, for example, an insulating nitride such as silicon nitride. The air spacer 375 may include air.

The fourth spacer 440 may cover an upper outer sidewall of the first spacer 360, a top end of the air spacer 375, and an upper surface and an upper outer sidewall of the third spacer 380. The fourth spacer 440 may include, e.g., an insulating nitride such as silicon nitride.

The contact plug structure may include a first lower contact plug 430, a second ohmic contact pattern 450 and an upper contact plug 485 sequentially stacked on the first active pattern 105 and the isolation structure in the vertical direction.

The first lower contact plug 430 may be disposed between the spacer structures 395 on respective opposite sidewalls of ones of first the bit line structures 355 neighboring in the first direction D1. A plurality of the lower contact plugs 430 may be spaced apart from each other in the second direction D2. Each of the first lower contact plugs 430 may be disposed on a corresponding one of the opposite end portions of the first active pattern 105, and may contact the impurity region 107 on the first active pattern 105. The first lower contact plug 430 may include, for example, polysilicon doped with n-type impurities or p-type impurities.

The fence pattern 420 may be disposed between ones of the first lower contact plugs 430 neighboring in the second direction D2 and may separate the ones of the lower contact plugs 430 from each other. Accordingly, the fence pattern 420 may be disposed between the spacer structures 395 on respective opposite sidewalls of ones of the first bit line structures 355 adjacent to each other in the first direction D1. A plurality of fence patterns 420 may be spaced apart from each other in the second direction D2. The fence pattern 420 may include, for example, an insulating nitride such as silicon nitride.

The second ohmic contact pattern 450 may be disposed the first lower contact plug 430, and may include, for example, a metal silicide such as titanium silicide, cobalt silicide, nickel silicide, etc.

The upper contact plug 485 may include a third metal pattern 475 and a barrier pattern 465 covering a lower surface of the third metal pattern 475. The upper contact plug 485 may be disposed on the second ohmic contact pattern 450, the first bit line structure 355, and the fence pattern 420. In example embodiments, the upper contact plug 485 may have a shape such as a circle, an ellipse, a polygon, a polygon with rounded corners, etc., in a plan view. The upper contact plugs 485 and may be arranged, for example, in a honeycomb pattern in the first and second directions D1 and D2 on the first region I of the first substrate 100.

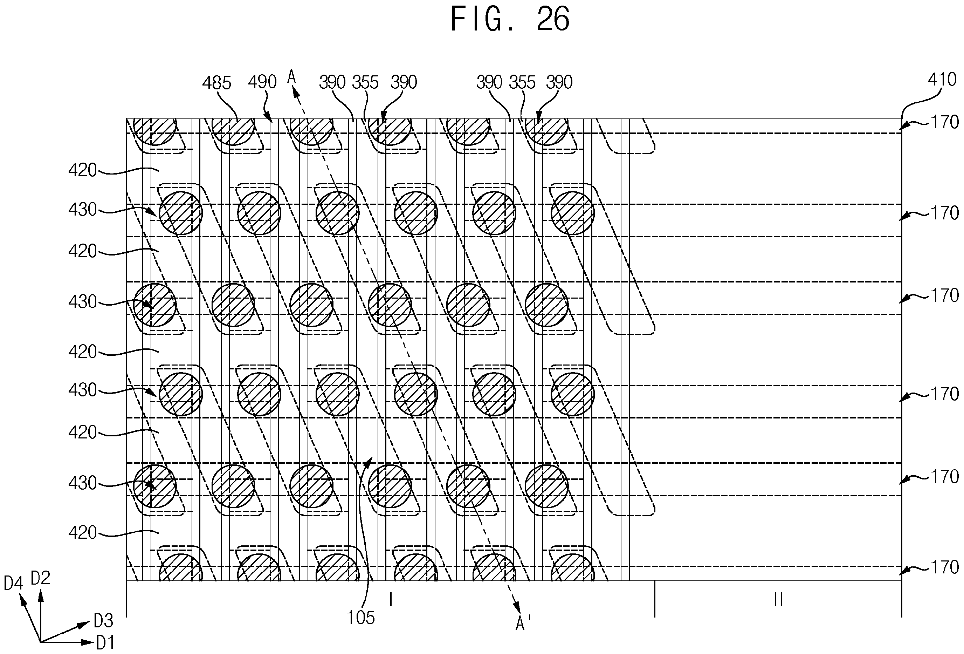

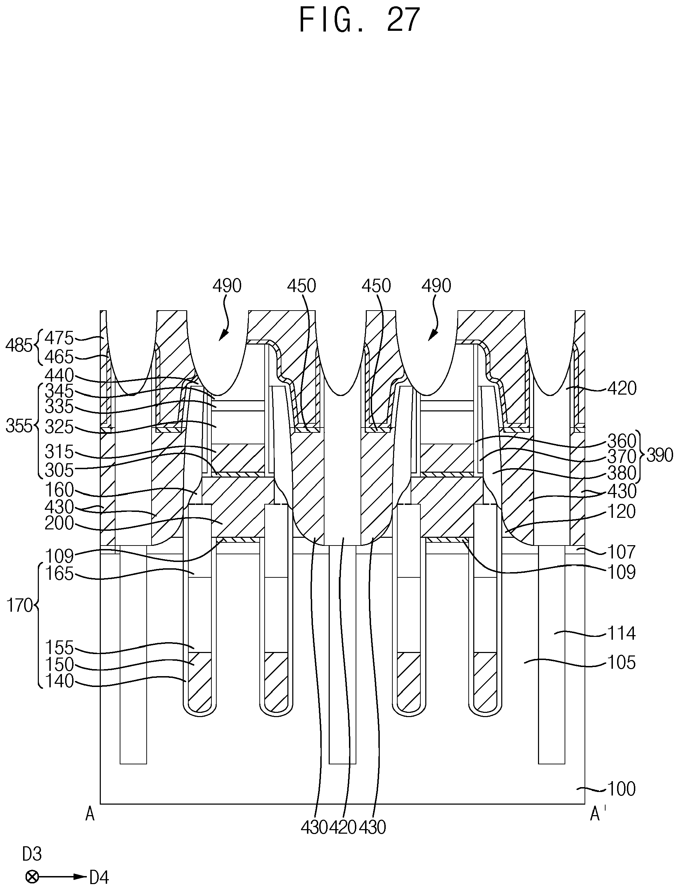

Referring to FIGS. 1 to 6 together with FIGS. 26 and 27, the second insulation pattern structure 520 may include a second insulation pattern 500 on an inner wall of a sixth opening 490, which may extend through the upper contact plug 485 and portions of the first insulation pattern structure included in the first bit line structure 355, the upper spacer structure 395 and the fourth spacer 440 and may surround the upper contact plug 485 in a plan view, and a third insulation pattern 510, which may be disposed on the second insulation pattern 500 and fill a remaining portion of the sixth opening 490. An upper end of the air spacer 375 may be closed by the second insulation pattern 500.

The second and third insulation patterns 500 and 510 may include, for example, an insulating nitride such as silicon nitride.

The first insulation pattern 410 may be disposed on the third isolation pattern 116 on the second region II of the first substrate 100. The second insulation pattern structure 520 may be disposed on the first insulation pattern 410. The first insulation pattern 410 may include an oxide, e.g., silicon oxide.

The stack structure may be disposed on the upper contact plug 485 and the second insulation pattern structure 520, and may include fourth insulation layers 600 and plate electrodes 610 alternately and repeatedly stacked in the vertical direction. In example embodiments, each of the fourth insulation layers 600 and each of the plate electrodes 610 included in the stack structure may have a flat-plate shape.

In example embodiments, each of the fourth insulation layers 600 may include, for example, an oxide such as silicon oxide, and each of the plate electrodes 610 may include, for example, polysilicon doped with impurities or silicon-germanium doped with impurities.

The capacitor may include a second electrode (, which may extend through the stack structure to contact an upper surface of the upper contact plug 485 on the first region I of the first substrate 100. The second electrode 660 may have a shape of a pillar extending in the vertical direction, a ferroelectric pattern 650, which may have a shape of a cylinder (e.g. cylindrical shape) surrounding a sidewall of the second electrode 660, and a first electrode 640, which may be disposed on an outer sidewall of the ferroelectric pattern 650 and protrude from the ferroelectric pattern 650 in the horizontal direction. In example embodiments, the first electrode 640 may have a shape of a ring surrounding the outer sidewall of the ferroelectric pattern 650, which may have a cylindrical shape.

In example embodiments, the first electrode 640 may contact a sidewall of a corresponding one of a plurality of plate electrodes 610 included in the stack structure. Thus one capacitor may include the plurality of first electrodes 640 spaced apart from each other in the vertical direction. Each of the first electrodes 640 may contact an upper surface or a lower surface of a corresponding one of a plurality of fourth insulation layers 600 included in the stack structure, however, may not contact a sidewall of the corresponding one of the plurality of fourth insulation layers 600.

FIG. 3 shows that a slope of a sidewall of each of the first electrodes 640 is substantially vertical. Meanwhile, FIG. 4 shows that the slope of the sidewall of each of the first electrodes 640 in some implementations may be convex toward the sidewall of the corresponding one of the plurality of plate electrodes 610.

In example embodiments, each of the first and second electrodes 640 and 660 may include, for example, a metal, a metal nitride, a metal silicide, etc.

In example embodiments, the ferroelectric pattern 650 may include a ferroelectric material and/or an antiferroelectric material.

In an example embodiment, the ferroelectric pattern 650 may include a ferroelectric material, for example, a perovskite material such as barium titanium oxide (BaTiOₓ), a hafnium-based fluorite material, or a hafnium zirconium oxide (HfₓZr₁₋ₓO_{y}).

In an example embodiment, the ferroelectric pattern 650 may include an antiferroelectric material such as, for example, zirconium oxide (ZrO₂), hafnium zirconium oxide (HfₓZr₁₋ₓO_{y}), lead zirconium oxide (PbZrO₃), sodium niobium oxide (NaNbO₃), etc_{.}

In an embodiment, the ferroelectric material or the antiferroelectric material of the ferroelectric pattern 650 may be doped with an element such as, for example, aluminum (Al), barium (Ba), silicon (Si), yttrium (Y), scandium (Sc), strontium (Sr), etc.

In an embodiment, the ferroelectric material or the antiferroelectric material of the ferroelectric pattern 650 may be doped with, for example, a lanthanum-based rare earth element.

The capacitor may include the ferroelectric pattern 650 including a ferroelectric material and/or an antiferroelectric material instead of a dielectric pattern including a paraelectric material, and may have non-volatile characteristics. Accordingly, a cell transistor that is electrically connected to the capacitor, e.g., a cell transistor including the first active pattern 105 and the gate structure 170 on the first substrate 100 may not necessarily have low leakage current characteristics.

Therefore, the first active pattern 105 serving as a channel in the cell transistor may include polysilicon or an oxide semiconductor material, e.g., IGZO instead of single crystal silicon, so that the first substrate 100 on which the cell transistor may be disposed may include, e.g., a polysilicon substrate as well as a bulk substrate.

FIGS. 1 to 6 show that the gate structure 170 included in the cell transistor is buried at upper portions of the first active patterns 105 and the isolation structure, and thus the cell transistor may be a so-called buried channel array transistor (BCAT). However, in some implementations, and the cell transistor may be one of various types of transistors, e.g., a planar transistor, a finFET, a gate all around (GAA) transistor, etc.

The capacitor may include a plurality of first electrodes 640 spaced apart from each other in the vertical direction, such that unit capacitors each including the second electrode 660, the ferroelectric pattern 650 and the first electrode 640 may be connected in series in the vertical direction.

In example embodiments, opposite edge portions in the first direction D1 of the stack structure may have a staircase shape. Accordingly, contact plugs for transferring electrical signals to the plate electrodes 610 at respective levels may be disposed on the second region II of the first substrate 100, and may be connected to the plate electrodes 610, respectively.

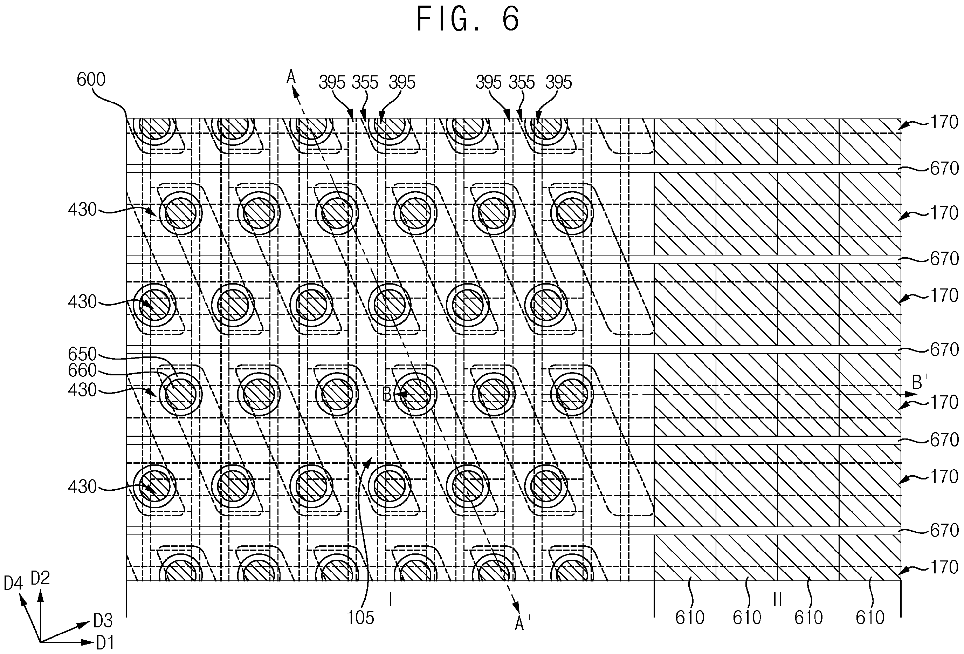

The stack structure shown in FIG. 6 may extend in the first direction D1 in the same way as the gate structure 170. A plurality of stack structures may be spaced apart from each other in the second direction D2 by the division pattern 670. Accordingly, different electrical signals may be applied to the plate electrodes 610, respectively, included in the stack structures.

Contact plugs may be formed on respective steps of the stack structure on the second region II of the first substrate 100. The contact plugs may extend in the vertical direction to contact upper surfaces of steps, respectively, of the stack structure, or may extend through the steps, respectively, of the stack structure in the first direction D1 on the second region II of the first substrate 100.

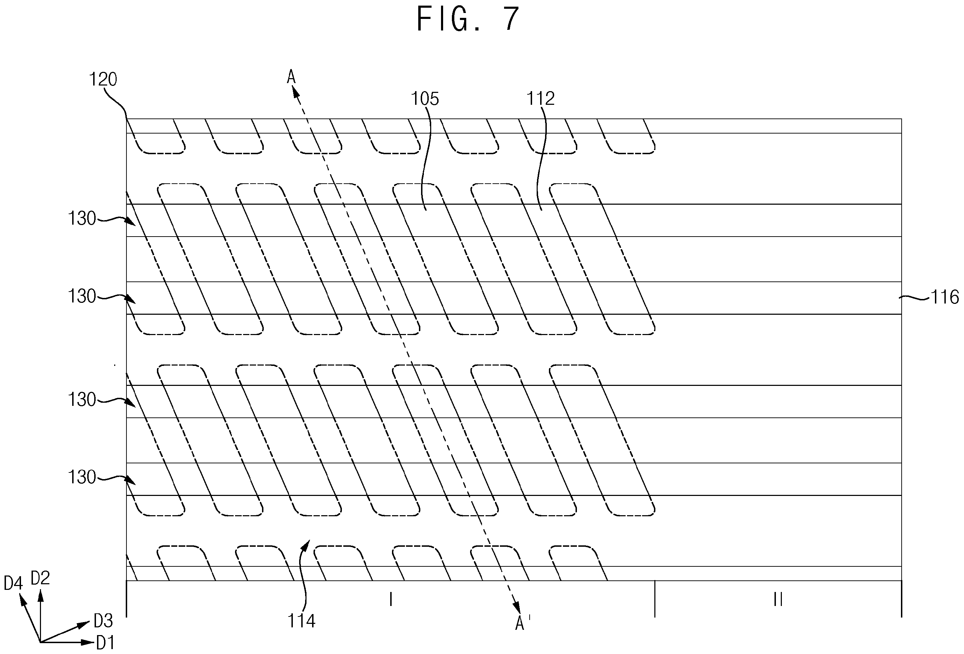

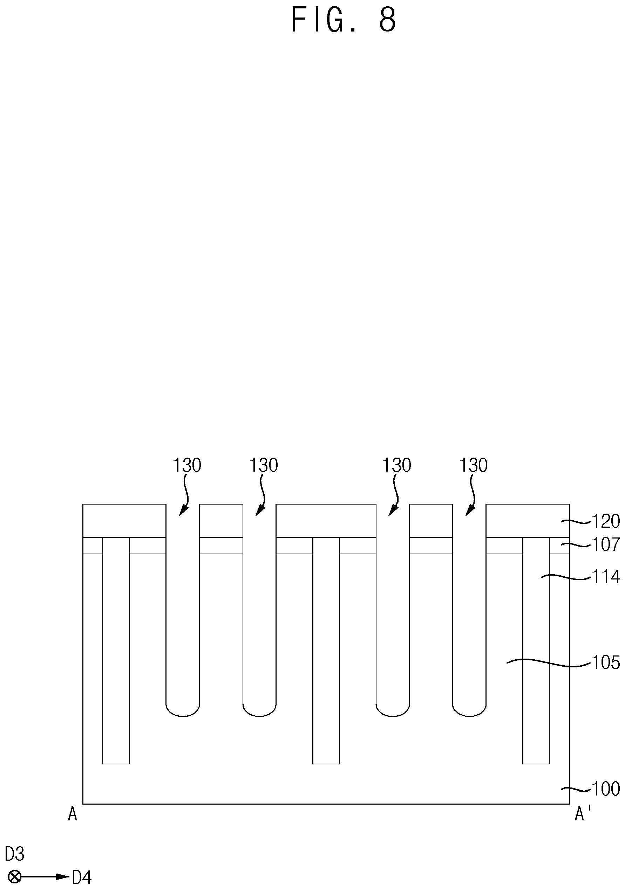

FIGS. 7 to 37 are plan views and cross-sectional views illustrating a method of manufacturing a semiconductor device in accordance with example embodiments. Specifically, FIGS. 7, 9, 12, 15, 18, 22, 26, 30 and 36 are the plan views, and FIGS. 8, 10, 11, 13-14, 16-17, 19-21, 23-25, 27- 29, 31-35 and 37 are cross-sectional views taken along lines A-A', respectively, of corresponding plan views.

Referring to FIGS. 7 and 8, an upper portion of a first substrate 100 may be removed to form first to third recesses, and an isolation structure filling the first to third recesses may be formed.

If the isolation structure is formed on the first substrate 100, a first active pattern 105, which may have a sidewall covered by the isolation structure, may be defined on the first substrate 100.

In example embodiments, the first recess may extend in the fourth direction D4 on a first region I of the first substrate 100, and a plurality of first recesses may be spaced apart from each other in the first direction D1. The second recess may extend in the first direction D1 on the first region I of the first substrate 100, and may be connected to the first recesses disposed in the first direction D 1. A plurality of second recesses may be spaced apart from each other in the second direction D2. The third recess may be formed on a second region II of the first substrate 100, and may be connected to the second recess on the first region I of the first substrate 100.

Accordingly, the isolation structure may include first to third isolation patterns 112, 114, and 116 respectively formed in the first to third recesses, which may be connected to each other.

In example embodiments, the first active pattern 105 may extend to a certain length in the fourth direction D4 on the first region I of the first substrate 100, and a plurality of the first active patterns 105 may be spaced apart from each other in the fourth direction D4 by the second isolation pattern 114. Additionally, a plurality of first active patterns 105 may be spaced apart from each other in the first direction D1 by the first isolation pattern 112.

A first impurity region 107 may be formed at an upper portion of the first active pattern 105 by doping, for example, n-type impurities or p-type impurities into the upper portion of the first active pattern 105.

In example embodiments, the first impurity region 107 may be formed by a gas phase doping (GPD) process.

A first pad layer may be formed on the first active pattern 105, which may include the first impurity region 107 at the upper portion thereof, and the isolation pattern. The first pad layer may be patterned to form a first pad 120, and the first active pattern 105 may be etched by an etching process using the first pad 120 as an etching mask to form a fourth recess 130.

The first pad 120 may include, for example, an oxide such as silicon oxide.

In example embodiments, the fourth recess 130 may extend in the first direction D1 in the first and second regions I and II of the first substrate 100. A plurality of fourth recesses 130 may be spaced apart from each other in the second direction D2. Each of the fourth recesses 130 may have a bottom higher than a bottom surface of the isolation structure.

In example embodiments, two fourth recesses 130 spaced apart from each other in the second direction D2 may be formed in each of the first active patterns 105. Hereinafter, the portion of each of the first active patterns 105 extending in the fourth direction D4, which may be between the fourth recesses 130, may be referred to as a central portion. A portion of each of the first active patterns 105 that may be between each of the fourth recesses 130 and the second isolation pattern 114 may be referred to as an end portion.

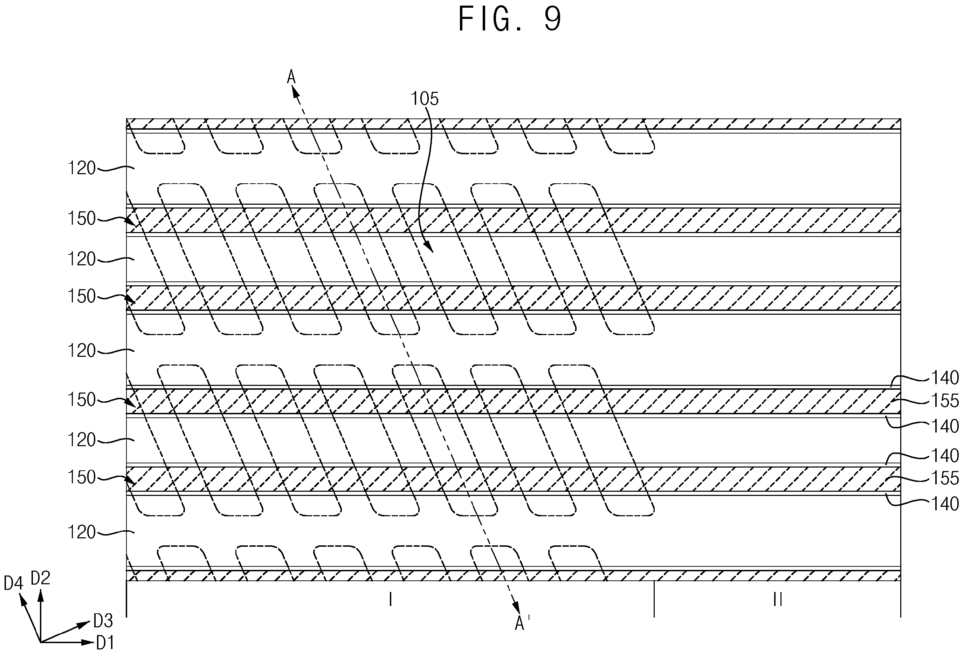

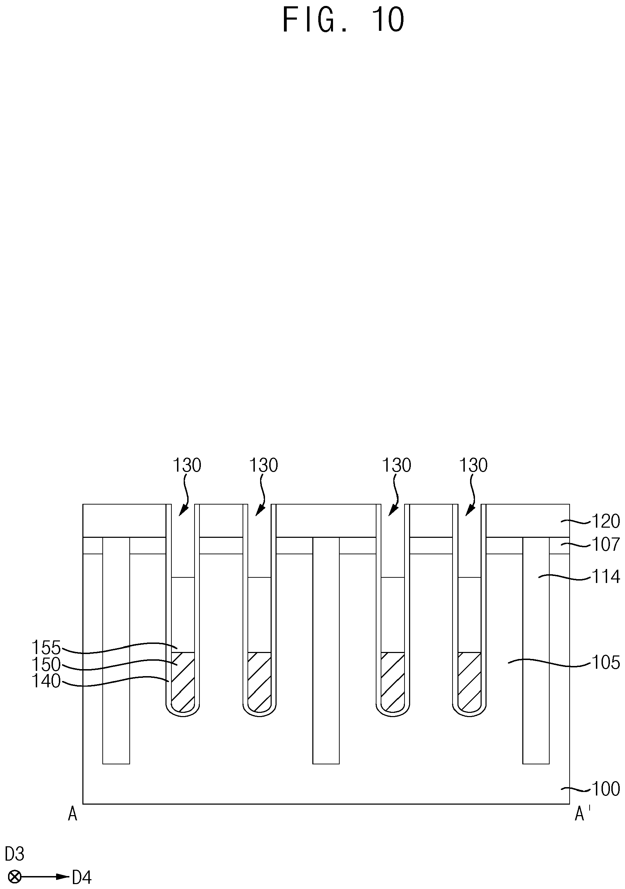

Referring to FIGS. 9 and 10, after forming a gate insulation layer on an inner wall of the fourth recess 130 and an upper surface of the first pad 120, a portion of the gate insulating layer on the upper surface of the first pad 120 may be removed to form a gate insulation pattern 140 on the inner wall of the fourth recess 130.

The gate insulation pattern 140 may include, e.g., an oxide such as silicon oxide.

A first conductive layer may be formed on the gate insulation pattern 140 and the first pad 120. An upper portion of the first conductive layer may be removed by, e.g., an etch-back process to form a first conductive pattern 150 in a lower portion of the fourth recess 130.

A second conductive layer may be formed on the first conductive pattern 150, the gate insulating pattern 140 and the first pad 120. An upper portion of the second conductive layer may be removed by, e.g., an etch-back process to form a second conductive pattern 155 in a middle portion of the fourth recess 130.

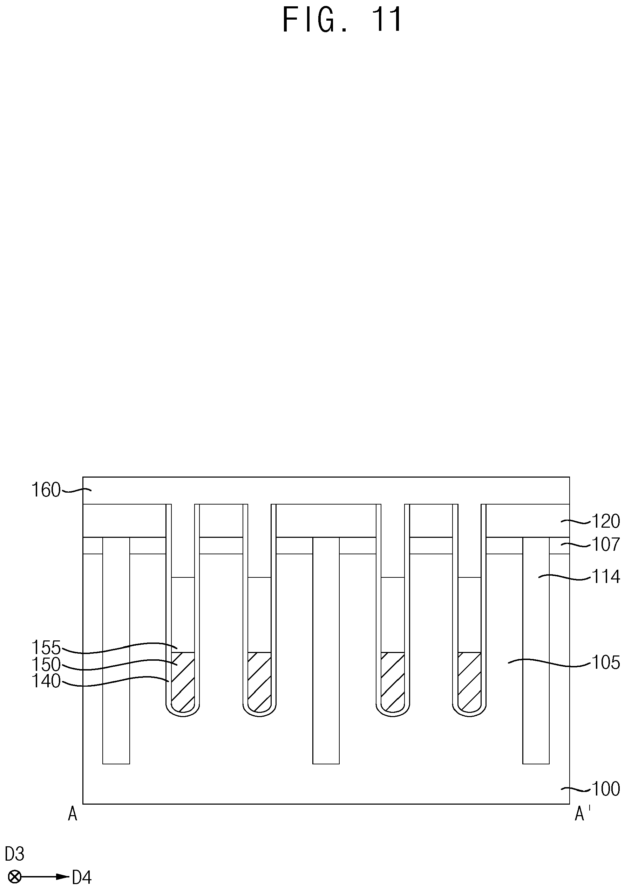

Referring to FIG. 11, a first capping layer 160 may be formed on the second conductive pattern 155, the gate insulation pattern 140 and the first pad 120 to fill an upper portion of the fourth recess 130.

The first capping layer 160 may include, e.g., a nitride such as silicon nitride.

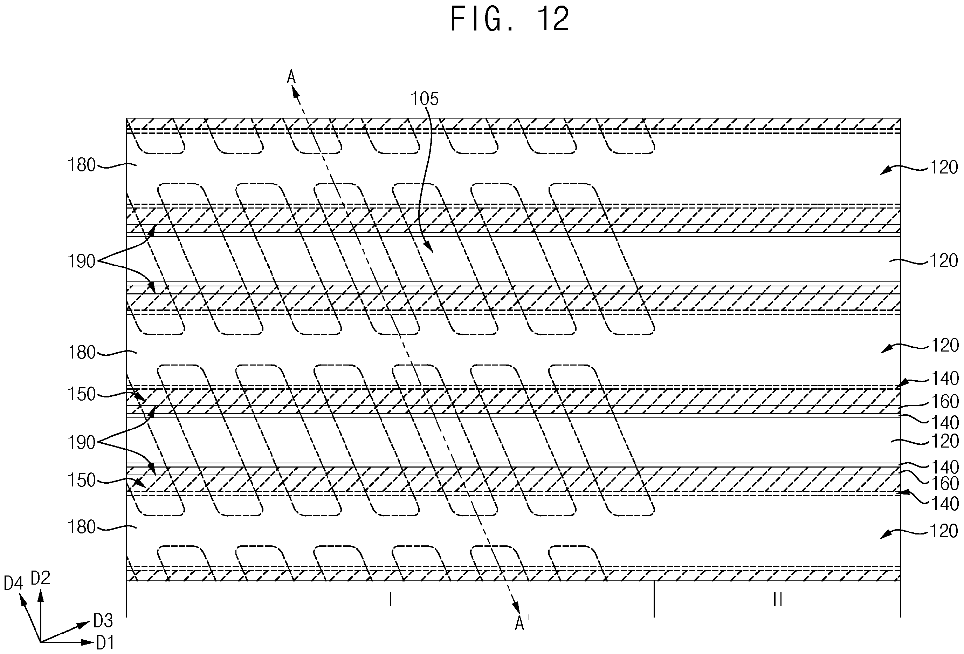

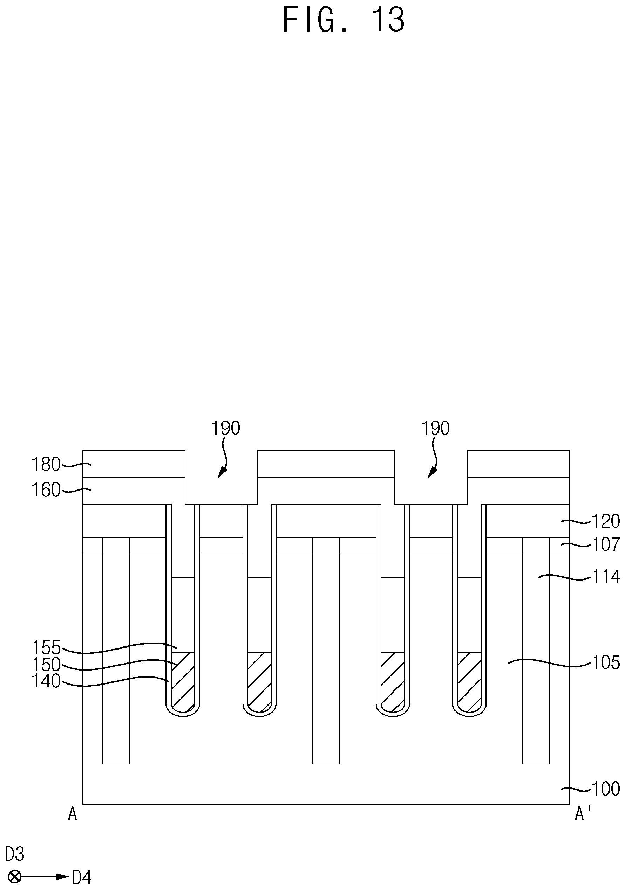

Referring to FIGS. 12 and 13, a first mask 180 may be formed on the first capping layer 160, and an etching process may be performed on the first capping layer 160 using the first mask 180 as an etching mask to form a first opening 190 exposing the upper surface of the first pad 120.

The first mask 180 may include, e.g., an amorphous carbon layer (ACL).

In example embodiments, the first opening 190 may extend in the first direction D1 on the first and second regions I and II of the first substrate 100, and a plurality of first openings 190 may be spaced apart from each other in the second direction D2. Each of the first openings 190 may overlap the central portions of corresponding ones of the first active patterns 105 disposed in the first direction D1 in a vertical direction substantially perpendicular to an upper surface of the first substrate 100.

Accordingly, each of the first openings 190 may expose an upper surface of a portion of the first pad 120 on the central portion of each of the first active patterns 105 and an upper surface of a portion of the gate insulation pattern 140 neighboring the portion of the first pad 120 in the second direction D2, and may also partially expose a portion of the first capping layer 160 in the fourth recess 130.

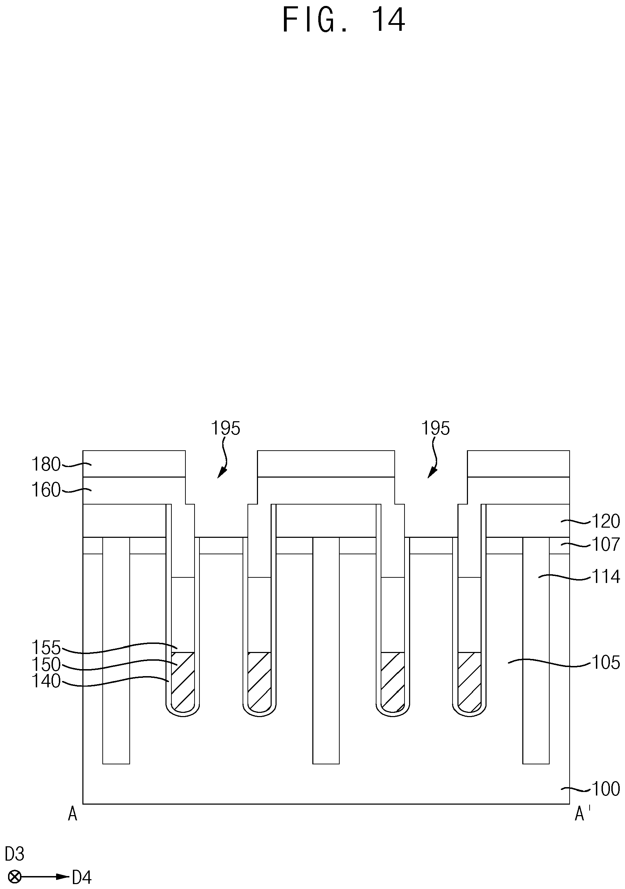

Referring to FIG. 14, the portion of the first pad 120 exposed by the first opening 190 and an upper portion of the portion of the gate insulation pattern 140 adjacent to the portion of the first pad 120 in the second direction D2 may be removed by an etching process.

In example embodiments, the etching process may include a wet etching process, and for example, the first pad 120 and the gate insulation pattern 140 including, e.g., an oxide such as silicon oxide may be partially removed, while the first capping layer 160 including, e.g., a nitride such as silicon nitride may not be removed.

As the etching process is performed, the first opening 190 may be enlarged in the vertical direction to form a second opening 195 that may expose an upper surface of the first impurity region 107 at the upper portion of the first active pattern 105 and an upper surface of the gate insulation pattern 140.

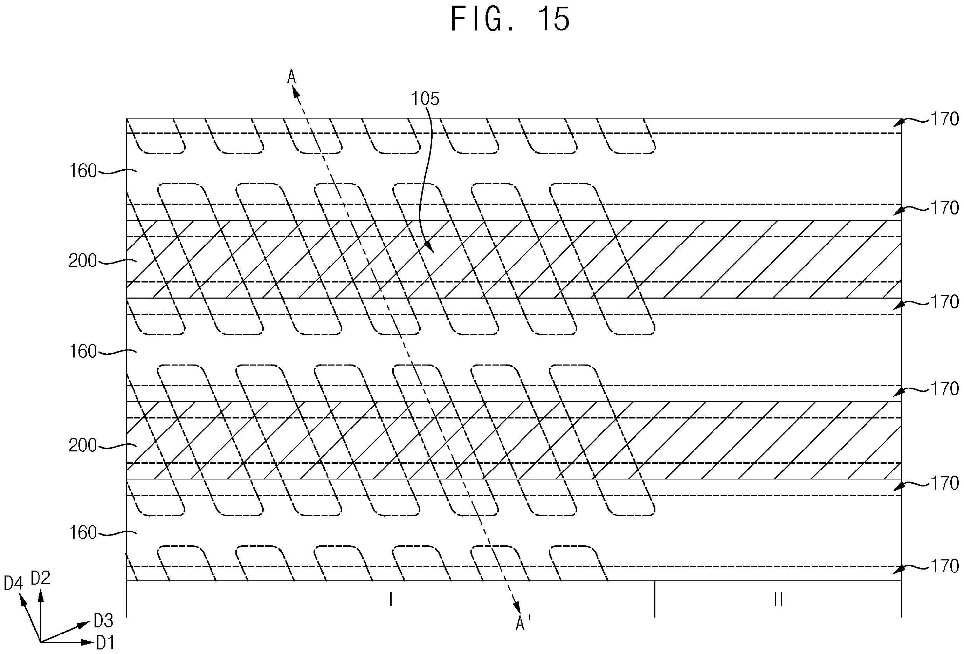

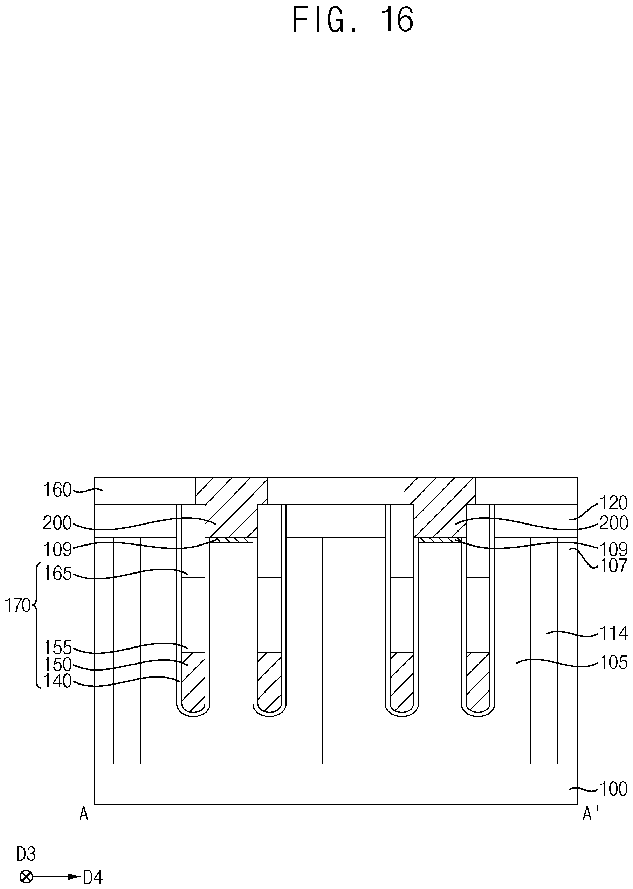

Referring to FIGS. 15 and 16, a first ohmic contact pattern 109 may be formed on the upper surface of the first impurity region 107 exposed by the second opening 195. A conductive filling pattern 200 may be formed to fill a remaining portion of the second opening 195.

The first ohmic contact pattern 109 may be formed by forming a first metal layer on the upper surface of the impurity region 107 and the upper surface of the gate insulation pattern 140 exposed by the second opening 195, a sidewall of the second opening 195 and an upper surface of the first capping layer 160, and performing a heat treatment process on the first metal layer such that a metal included in the first metal layer and silicon included in the first impurity region 107 may be reacted with each other. A portion of the first metal layer that is not reacted with silicon may be removed.

In example embodiments, the first ohmic contact pattern 109 may be formed on each of the first active patterns 105 disposed in the first direction D1, and thus, a plurality of first ohmic contact patterns 109 may be spaced apart from each other in the second direction D2.

The conductive filling pattern 200 may be formed by forming a third conductive layer on the first ohmic contact pattern 109 and the first mask 180 to fill the second opening 195, and performing a planarization process on the third conductive layer until the upper surface of the first capping layer 160 is exposed. During the planarization process, the first mask 180 may be removed. The planarization process may include, for example, a chemical mechanical polishing (CMP) process and/or an etch back process.

In example embodiments, the conductive filling pattern 200 may extend in the first direction D1, and a plurality of conductive filling patterns 200 may be spaced apart from each other in the second direction D2.

A portion of the first capping layer 160 that is on and has substantially the same width as the second conductive pattern 155, of which a sidewall may be covered by the gate insulating pattern 140, may be referred to as a first capping pattern 165. An upper portion of the first capping pattern 165 may contact a sidewall of a lower portion of the conductive filling pattern 200. The gate insulation pattern 140, the first conductive pattern 150, the second conductive pattern 155 and the first capping pattern 165 may be sequentially stacked on the gate insulation pattern 140, the sidewalls of which may contact an inner sidewall of the gate insulation pattern 140, may collectively form a gate structure 170.

Hereinafter, a remaining portion of the first capping layer 160 that may not form the first capping pattern 165, that is, a portion of the first capping layer 160 that may be formed on the first pad 120, the gate insulation pattern 140 and the first capping pattern 165 and have an upper surface substantially coplanar with an upper surface of the conductive filling pattern 200, may be referred to as a second pad 160.

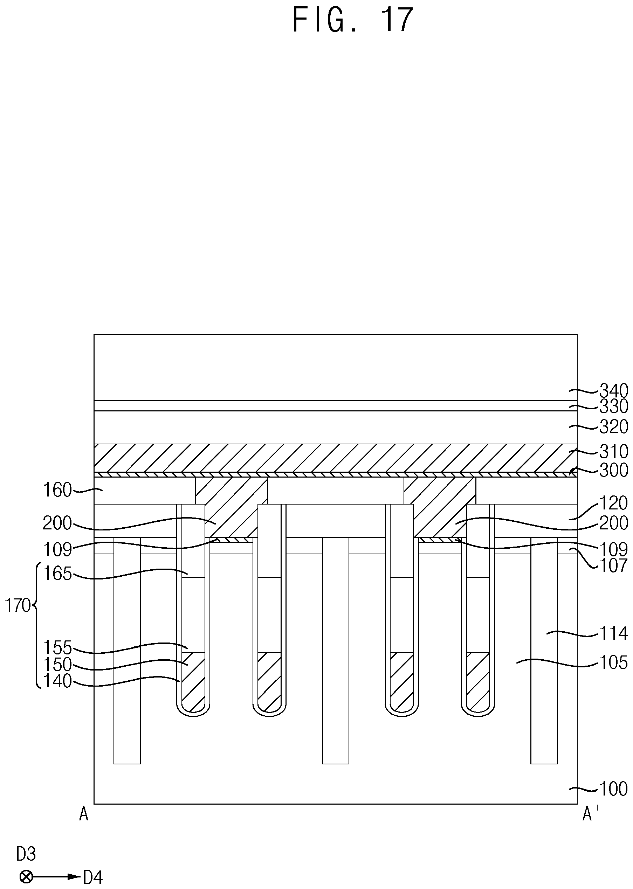

Referring to FIG. 17, an adhesive layer 300, a fourth conductive layer 310, a second mask layer 320, an etch stop layer 330 and a second capping layer 340 may be stacked sequentially on the second pad 160 and the conductive filling pattern 200.

Each of the second mask layer 320, the etch stop layer 330 and the second capping layer 340 may include an insulating material, for example, a nitride such as silicon nitride. The second mask layer 320, the etch stop layer 330 and the second capping layer 340 may collectively form an insulation layer structure, and in some cases, may be merged with each other to form a single layer.

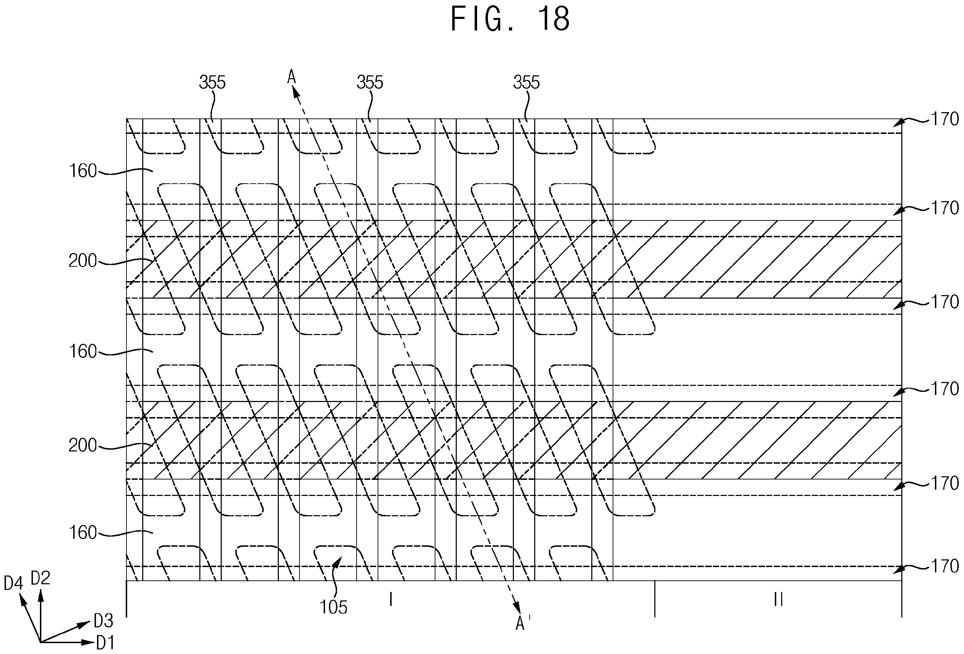

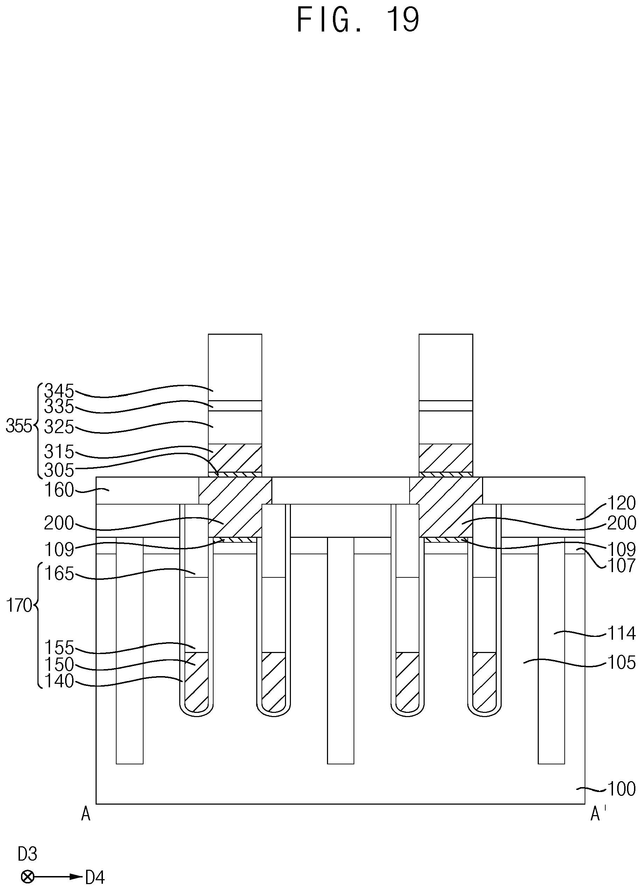

Referring to FIGS. 18 and 19, the second capping layer 340 may be etched to form a second capping pattern 345. The etch stop layer 330, the second mask layer 320, the fourth conductive layer 310 and the adhesive layer 300 may be sequentially etched by an etching process using the second capping pattern 345 as an etching mask.

Accordingly, a first bit line structure 355 extending in the second direction D2 may be formed on the conductive filling pattern 200 and the second pad 160 on the first region I of the first substrate 100. The plurality of first bit line structures 355 may be spaced apart from each other in the first direction D1. Each of the first bit line structures 355 may contact the upper surfaces of the conductive filling patterns 200 on the central portions of the first active patterns 105, respectively, disposed in the second direction D2.

The first bit line structure 355 may include the adhesive pattern 305, the fourth conductive pattern 315, the second mask 325, the etch stop pattern 335 and the second capping pattern 345 sequentially stacked in the vertical direction. The second mask 325, the etch stop pattern 335 and the second capping pattern 345 may collectively form a first insulation pattern structure.

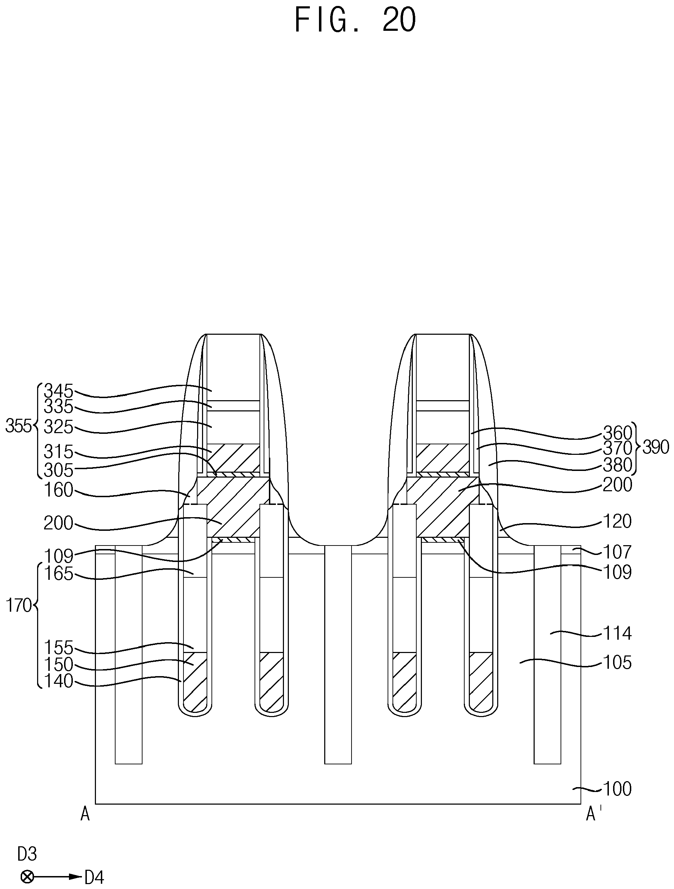

Referring to FIG. 20, a first spacer layer may be formed on the first bit line structure 355, the conductive filling pattern 200 and the second pad 160. A second spacer layer may be formed on the first spacer layer.

An anisotropic etching process may be performed on the first and second spacer layers, and thus first and second spacers 360 and 370 stacked in the first direction D1 may be formed on a sidewall of the first bit line structure 355 in the first direction D1. A cross section of the first spacer 360 in the first direction D1 may have an "L" shape. The first spacer 360 may include a nitride, e.g., silicon nitride, and the second spacer 370 may include an oxide, e.g., silicon oxide.

During the formation of the first and second spacers 360 and 370, a portion of the second pad 160 and an upper portion of the conductive filling pattern 200 that may not be covered by the first and second spacers 360 and 370 may also be removed, and thus the upper surface of the first pad 120 and an upper surface of the lower portion of the conductive filling pattern 200 may be exposed.

A third spacer layer may be formed on the first bit line structure 355, the first and second spacers 360 and 370, the conductive filling pattern 200 and the first pad 120. An anisotropic etching process may be performed on the third spacer layer to form a third spacer 380. Accordingly, a preliminary spacer structure 390, which may include the first to third spacers 360, 370 and 380 sequentially stacked in the first direction D1, may be formed on the sidewall of the first bit line structure 355 in the first direction D 1. The third spacer 380 may include a nitride, e.g., silicon nitride.

During the formation of the third spacer 380, a portion of the first pad 120 and the lower portion of the conductive filling pattern 200, which may not be covered by the preliminary spacer structure 390, and a portion of the first ohmic contact pattern 109 under the conductive filling pattern 200, may also be removed such that the upper surface of the first impurity region 107 at the upper portion of the first active pattern 105 and an upper surface of the isolation structure adjacent to the first impurity region 107 may be exposed.

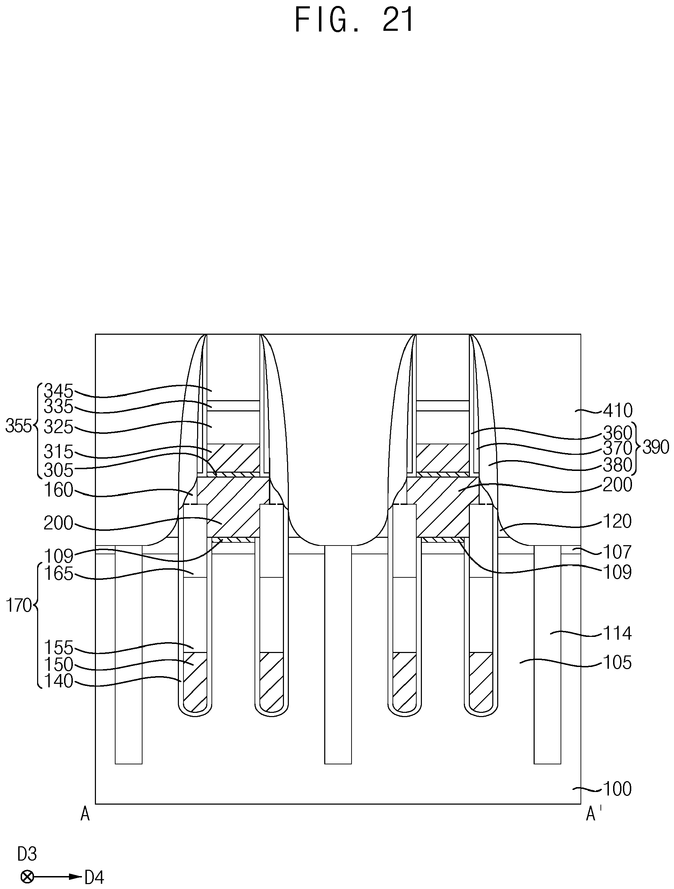

Referring to FIG. 21, a sacrificial layer may be formed on the first bit line structure 355, the preliminary spacer structure 390, the first active pattern 105 and the isolation structure. An upper portion of the sacrificial layer may be planarized until an upper surface of the first bit line structure 355 is exposed.

In example embodiments, the sacrificial pattern 410 may extend in the second direction D2 on the first region I of the first substrate 100, and a plurality of sacrificial patterns 410 may be spaced apart from each other in the first direction D1 by the first bit line structures 355. The sacrificial pattern 410 may cover the upper surface of the isolation structure on the second region II of the first substrate 100. The sacrificial pattern 410 may include an oxide, e.g., silicon oxide.

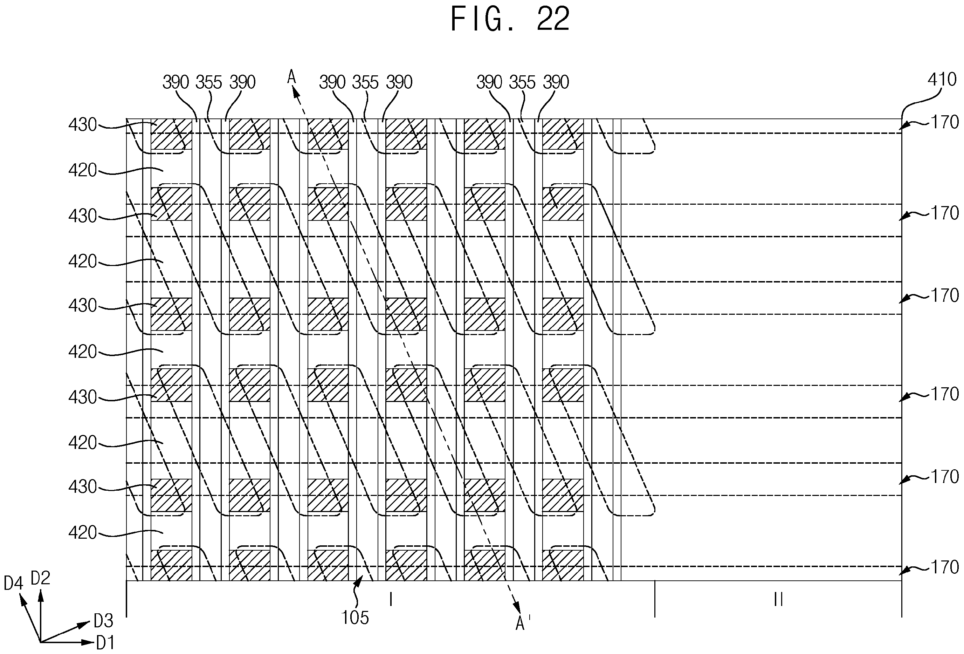

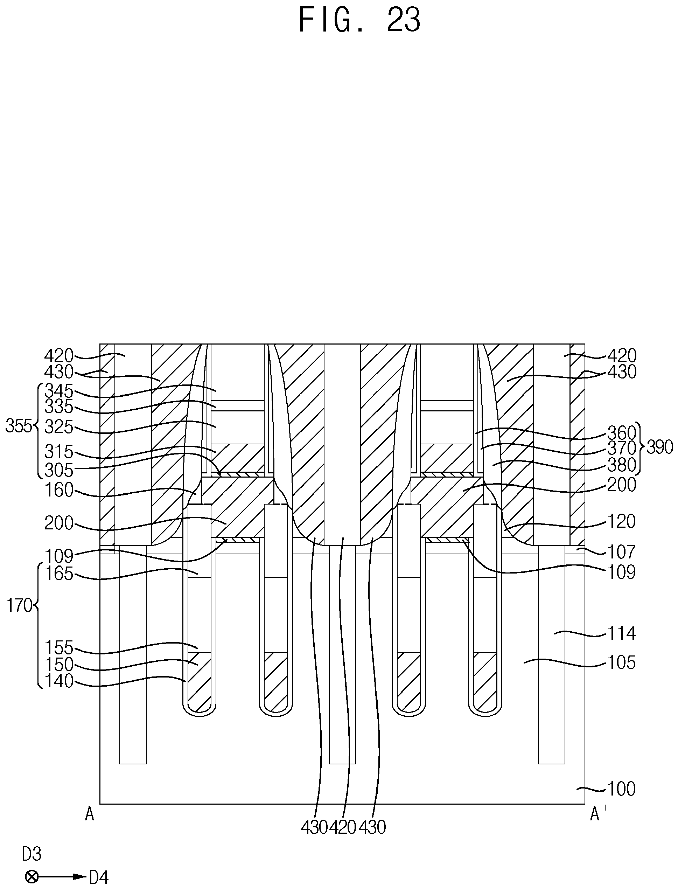

Referring to FIGS. 22 and 23, a third mask including a plurality of third openings spaced apart from each other in the second direction D2, each of which may extend in the first direction D1 on the first region I of the first substrate 100, may be formed on the first bit line structure 355, the preliminary spacer structure 390 and the sacrificial pattern 410. The sacrificial pattern 410 may be etched using the third mask as an etching mask.

In example embodiments, each of the third openings may overlap in the vertical direction the central portions of corresponding ones of the first active patterns 105 or the second isolation pattern 114 on the first region I of the first substrate 100. By the etching process, a fourth opening exposing the upper surfaces of the first active pattern 105 or the isolation structure may be formed on the first substrate 100 between ones of the first bit line structures 355 adjacent to each other in the first direction D1.

After removing the third mask, a fence layer may be formed to fill the fourth opening. An upper portion of the fence layer may be planarized until the upper surface of the first bit line structure 355 is exposed. Accordingly, the fence layer may be divided into a plurality of fence patterns 420 spaced apart from each other in the second direction D2 between ones of the first bit line structures 355 adjacent to each other in the first direction D1. The fence pattern 420 may include, for example, a nitride such as silicon nitride.

The sacrificial pattern 410 extending in the second direction D2 between the first bit line structures 355 may be separated into a plurality of parts spaced apart from each other in the second direction D2 by the fence patterns 420.

The sacrificial pattern 410 on the first region I of the first substrate 100 may be removed to form a fifth opening, and a first lower contact plug 430 may be formed in the fifth opening. In example embodiments, a plurality of first lower contact plugs 430 may be spaced apart from each other in the second direction D2 by fence patterns 420 on the first region I of the first substrate 100 between the first bit line structures 355. Each of the first lower contact plugs 430 may contact the upper surface of the first impurity region 107 at the upper portion of an end portion in the fourth direction D4 of a corresponding one of the first active patterns 105. The first lower contact plug 430 may include, for example, polysilicon doped with n-type impurities or p-type impurities.

A portion of the sacrificial pattern 410 on the second region II of the first substrate 100 may remain and may be referred to as a first insulation pattern 410 hereinafter.

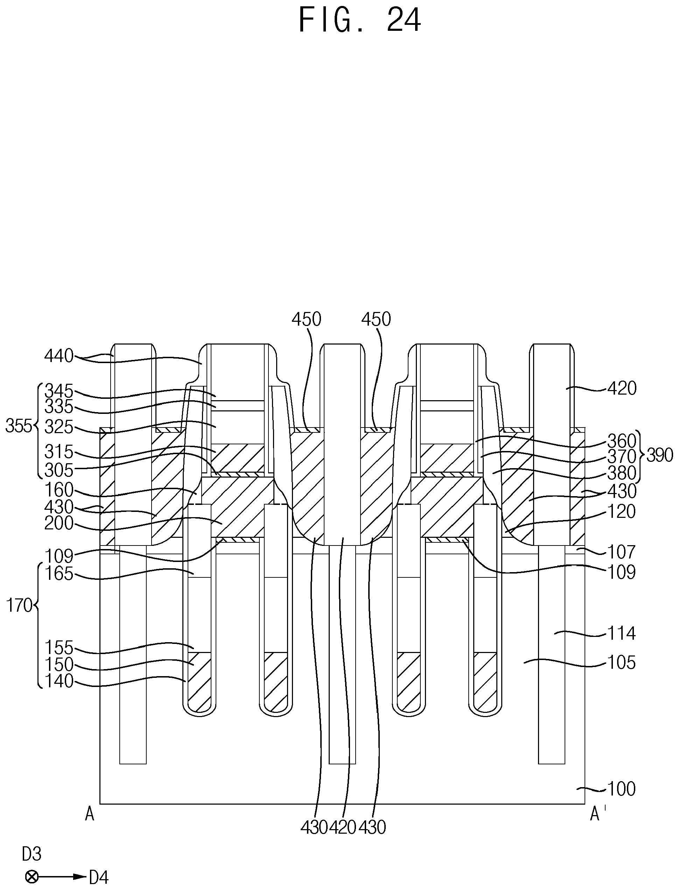

Referring to FIG. 24, after removing an upper portion of the first lower contact plug 430 to expose an upper portion of the preliminary spacer structure 390 on the sidewall of the first bit line structure 355, upper portions of the second and third spacers 370 and 380 of the exposed preliminary spacer structure 390 may be removed.

An upper portion of the first lower contact plug 430 may be additionally removed. Thus, the first lower contact plug 430 may have an upper surface lower than a top surfaces of the second and third spacers 370 and 380.

A fourth spacer layer may be formed on the first bit line structure 355, the preliminary spacer structure 390, the fence pattern 420 and the first lower contact plug 430, and may be anisotropically etched to form a fourth spacer 440 covering an upper portion of the preliminary spacer structure 390 on each of opposite sidewalls of the first bit line structure 355 in the first direction D1. Accordingly, the upper surface of the first lower contact plug 430 may be exposed.

A second ohmic contact pattern 450 may be formed on the exposed upper surface of the first lower contact plug 430. In example embodiments, the second ohmic contact pattern 450 may be formed by forming a second metal layer on the first bit line structure 355, the preliminary spacer structure 390, the fourth spacer 440, the fence pattern 420, the first lower contact and the first insulation pattern 410 and performing a heat treatment process on the second metal layer such that a metal included in the second metal layer and silicon included in the first lower contact plug 430 may react with each other. A portion of the second metal layer that is not reacted with silicon may be removed.

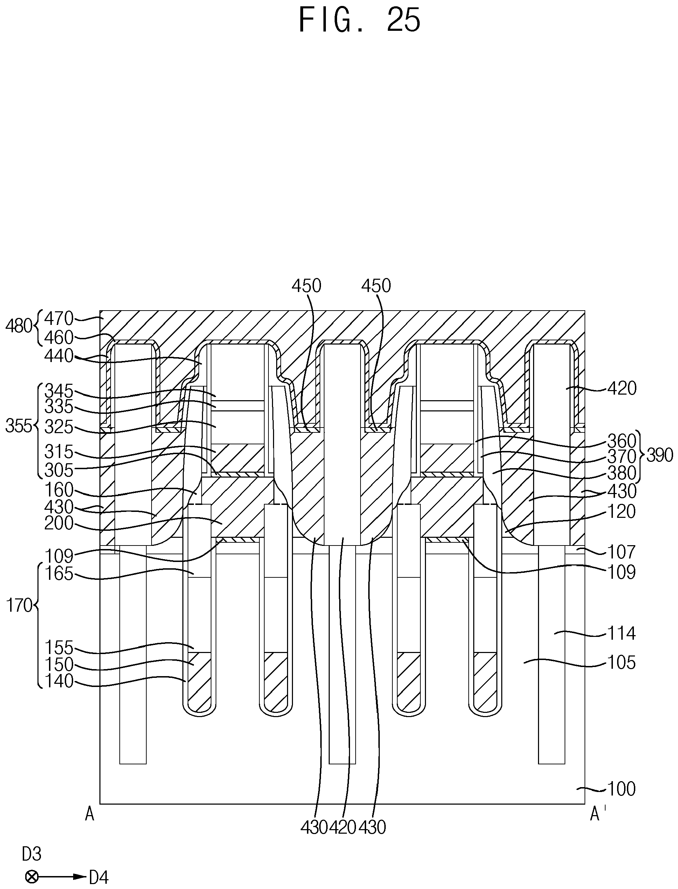

Referring to FIG. 25, after a barrier layer 460 is formed on the first bit line structure 355, the preliminary spacer structure 390, the fourth spacer 440, the fence pattern 420, the second ohmic contact pattern 450 the first insulation pattern 410, and a third metal layer 470 may be formed on the barrier layer 460 to fill a space between the first bit line structures 355.

In some embodiments, a planarization process may be further performed on an upper portion of the third metal layer 470. The planarization process may include, for example, a chemical mechanical polishing (CMP) process and/or an etch back process.

Referring to FIGS. 26 and 27, the third metal layer 470 and the barrier layer 460 may be patterned to form an upper contact plug 485. A sixth opening 490 may be formed between the upper contact plugs 485.

The sixth opening 490 may be formed by partially removing not only the third metal layer 470 and the barrier layer 460, but also the first insulation pattern structure in the first bit line structure 355, the preliminary spacer structure 390 and the fourth spacer 440 on the first region I of the first substrate 100.

The upper contact plug 485 may include a third metal pattern 475 and a barrier pattern 465 covering a lower surface of the third metal pattern 475. In example embodiments, the upper contact plug 485 may have a shape such as, for example, a circle, an ellipse, a polygon, a polygon with rounded corners, etc., The upper contact plugs 485 may be arranged, for example, in a honeycomb pattern in the first and second directions D1 and D2, in a plan view.

The lower contact plug 430, the second ohmic contact pattern 450, and the upper contact plug 485 sequentially stacked in the vertical direction on the first region I of the first substrate 100, may collectively form a contact plug structure.

During the formation of the sixth opening 490, portions of the third metal layer 470 and the barrier layer 460 on the first insulation pattern 410 on the second region II of the first substrate 100 may be removed, and thus an upper surface of the first insulation pattern 410 may be exposed.

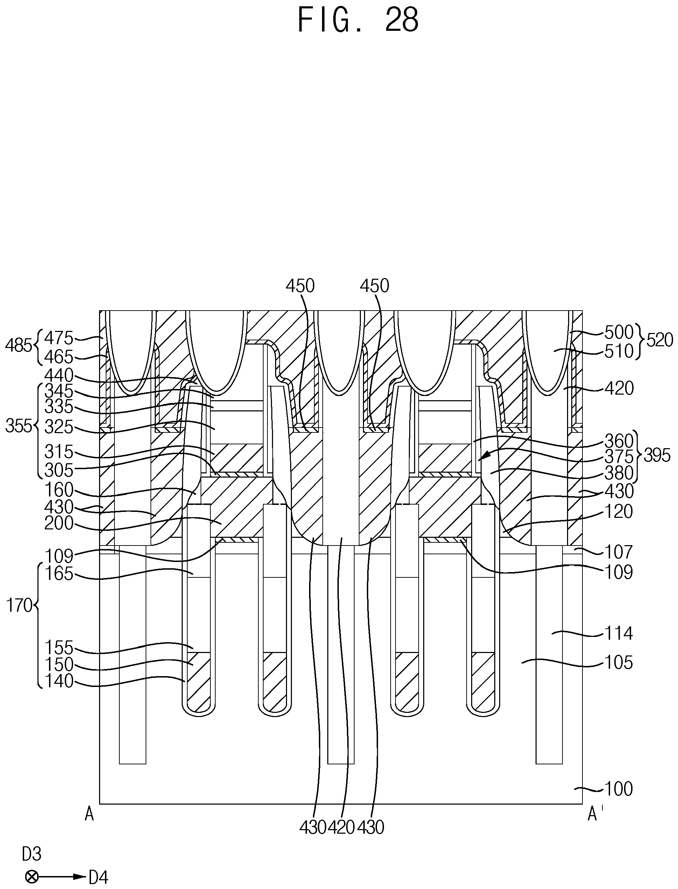

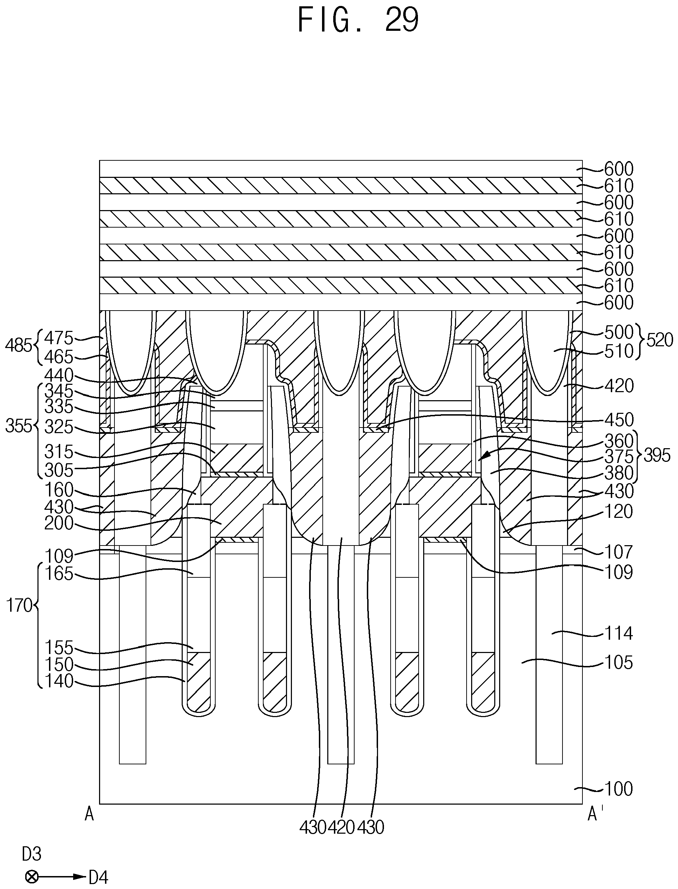

Referring to FIGS. 28 and 29, the second spacer 370 included in the preliminary spacer structure 390 exposed by the sixth opening 490 on the first region I of the first substrate 100 may be removed to form an air gap. A second insulation pattern 500 may be formed on a bottom and a sidewall of the sixth opening 490, and a third insulation pattern 510 filling a remaining portion of the sixth opening 490 may be formed.

The second and third insulation patterns 500 and 510 may collectively form a second insulation pattern structure 520.

An upper end of the air gap may be covered by the second insulation pattern 500, and thus, an air spacer 375 may be formed. The first spacer 360, the air spacer 375, and the third spacer 380 may collectively form a spacer structure 395.

In some example embodiments, the second spacer 370 may not be removed. In this case, instead of the spacer structure 395 including the air spacer 375, the preliminary spacer structure 390 including the second spacer 370 may remain.

The second insulation pattern structure 520 may be formed on the first insulation pattern 410 in the second region II of the first substrate 100.

Referring to FIG. 29, a fourth insulation layer 600 and a plate electrode 610 may be alternately and repeatedly stacked on the second insulation pattern structure 520 and the upper contact plug 485 in the vertical direction. Thus, a stack structure including the fourth insulation layers 600 and the plate electrodes 610 may be formed.

FIG. 29 shows that the fourth insulation layer 600 and the plate electrode 610 are formed with 5 levels and 4 levels, respectively. However, it is to be understood that other stacking structures may be provided.

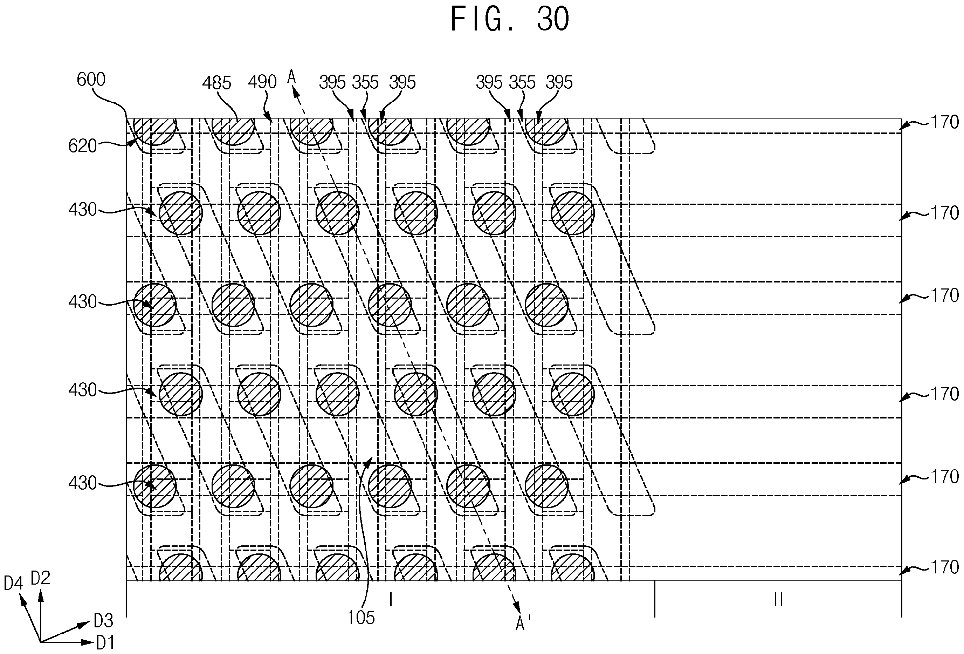

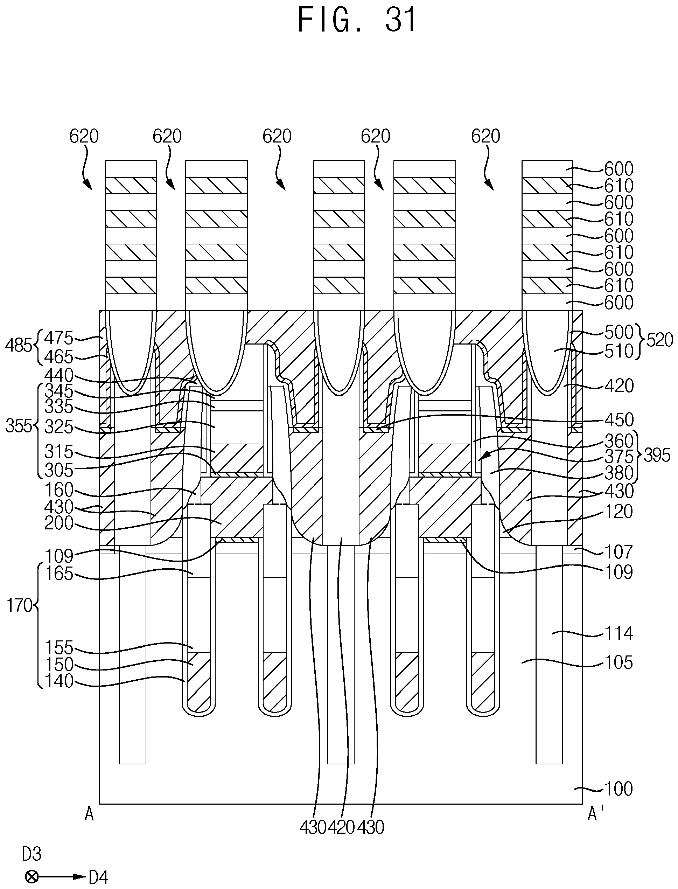

Referring to FIGS. 30 and 31, a seventh opening 620 may be formed through the stack structure to expose an upper surface of the upper contact plug 485.

A plurality of upper contact plugs 485 may be spaced apart from each other in the first and second directions D1 and D2 on the first region I of the first substrate 100 Thus, a plurality of the seventh openings 620 may also be spaced apart from each other in the first and second directions D1 and D2 in the first region I.

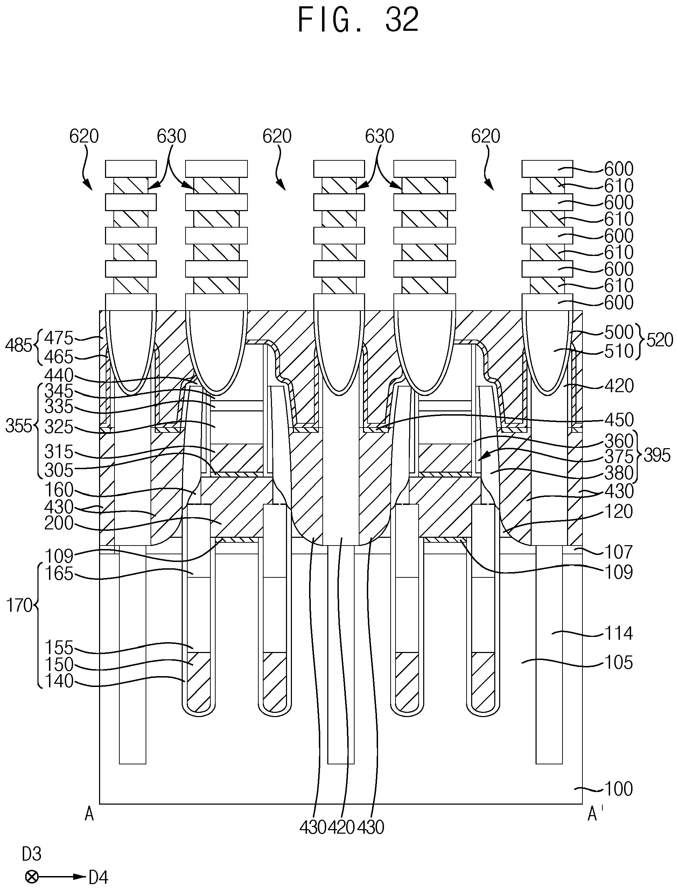

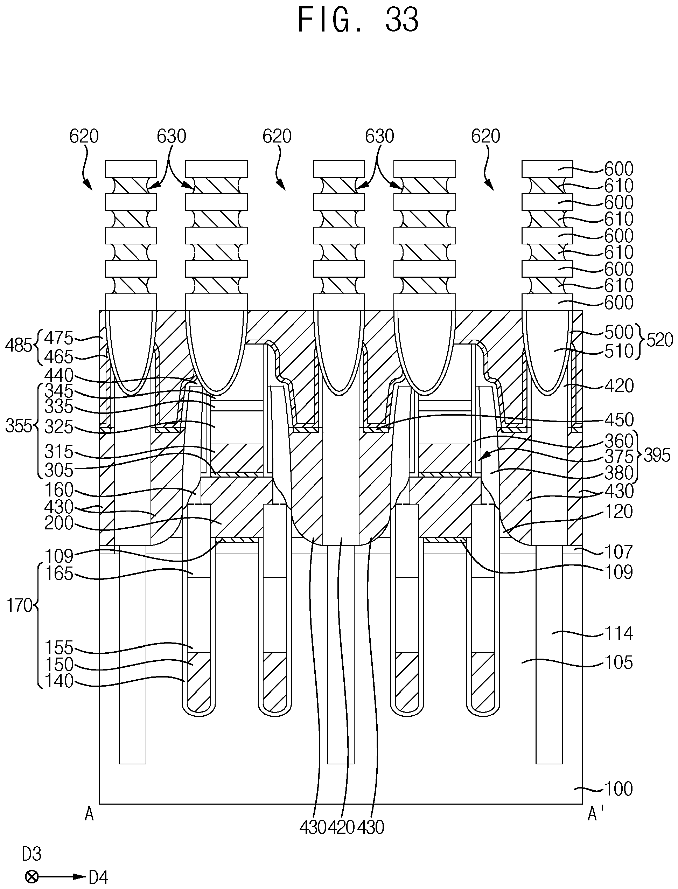

Referring to FIGS. 32 and 33, a lateral portion of the plate electrode 610 exposed by the seventh opening 620 may be removed to form a fifth recess 630.

In example embodiments, the fifth recess 630 may be formed by a wet etching process. Accordingly, a sidewall of the plate electrode 610 exposed by the fifth recess 630 may have a concave shape in a horizontal direction, as shown in FIG. 33.

In some implementations, referring to FIG. 32, the sidewall of the plate electrode 610 exposed by the fifth recess 630 may be substantially perpendicular to the upper surface of the first substrate 100.

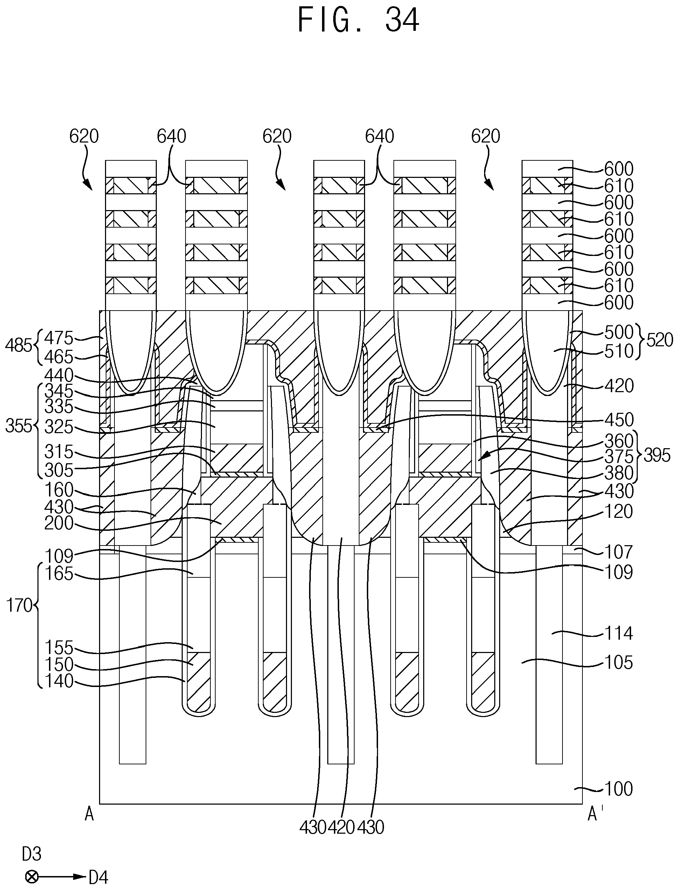

Referring to FIG. 34, a first electrode 640 may be formed in the fifth recess 630.

In example embodiments, the first electrode 640 may be formed by forming a first electrode layer on the upper surfaces of the upper contact plugs 485 exposed by the seventh opening 620, the sidewalls of the plate electrode 610, upper and lower surfaces and sidewalls of the fourth insulation layers 600, and the upper surface of the first insulation pattern 410, and performing, for example, a wet etching process on the first electrode layer.

Accordingly, the first electrode 640 may be formed to contact the sidewall of the plate electrode 610.

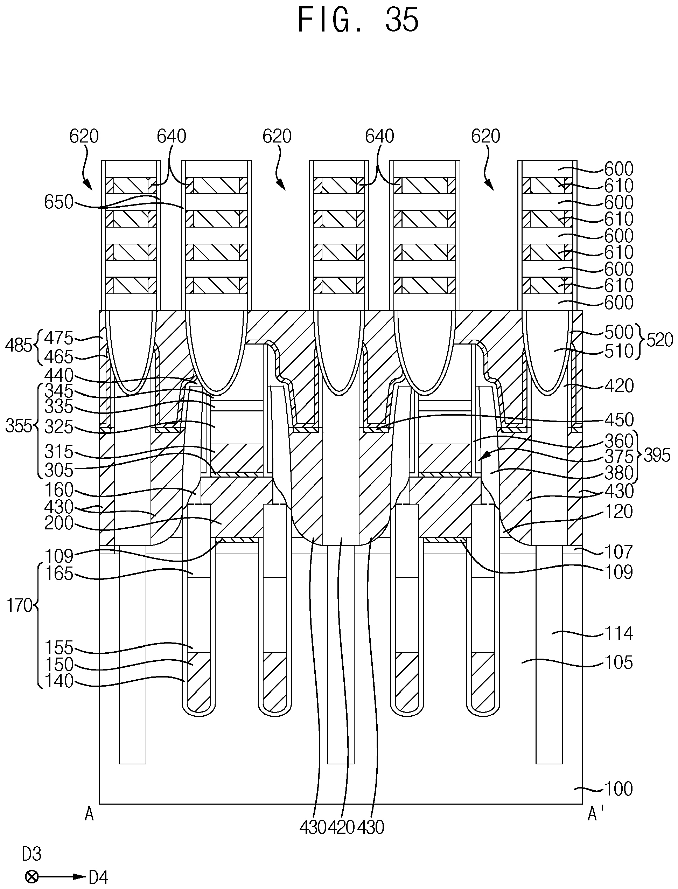

Referring to FIG. 35, a ferroelectric pattern 650 may be formed on a sidewall of the seventh opening 620.

In example embodiments, the ferroelectric pattern 650 may be formed by forming a ferroelectric layer on the upper surfaces of the upper contact plugs 485, sidewalls of the first electrodes 640, the sidewalls of the fourth insulation layers 600 and the upper surface of the first insulation pattern 410, and performing, for example, a wet etching process on the ferroelectric layer.

Accordingly, the ferroelectric pattern 650 may be formed to contact the sidewalls of the first electrodes 640 and the sidewalls of the fourth insulation layer 600.

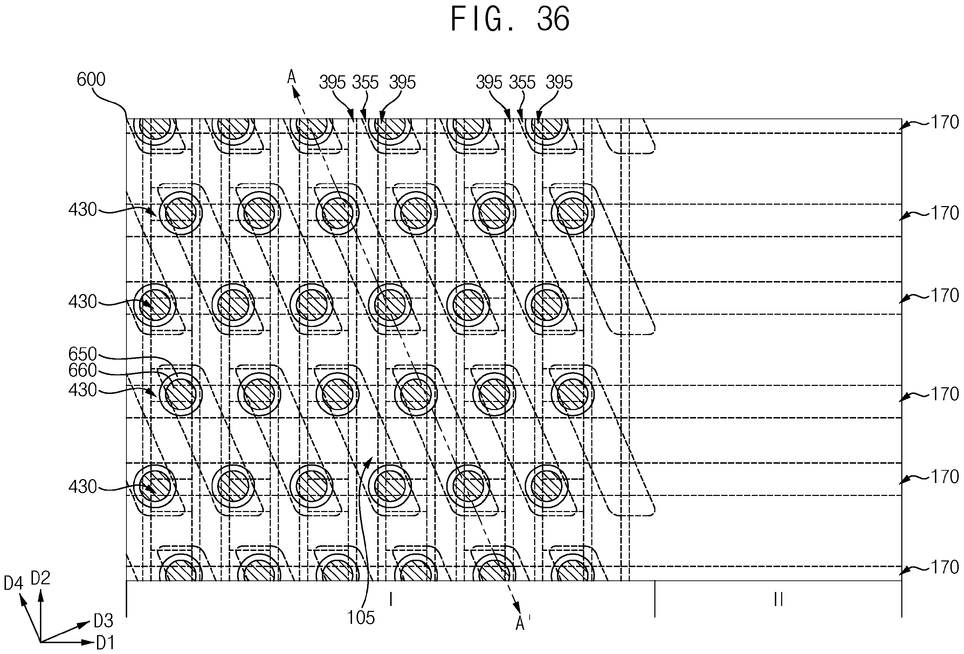

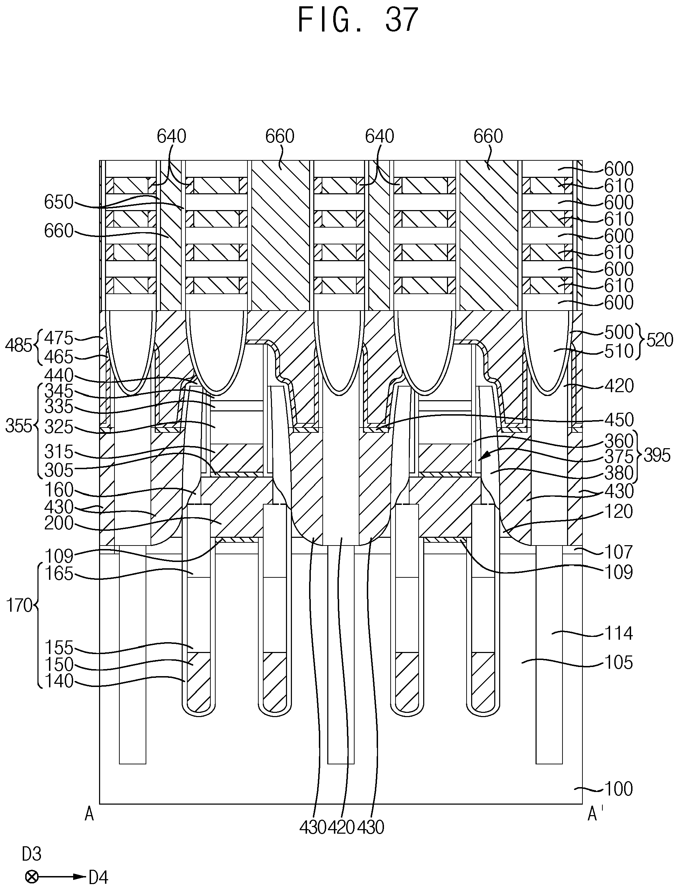

Referring to FIGS. 36 and 37, a second electrode 660 may be formed in the seventh opening 620.

In example embodiments, the second electrode 660 may be formed by forming a second electrode layer on the upper contact plugs 485, the ferroelectric patterns 650, the fourth insulation layers 600 and the first insulation pattern 410 to fill a remaining portion of the seventh opening 620, and performing a planarization process on the second electrode layer until an upper surface of an uppermost one of the fourth insulation layers 600 is exposed. Accordingly, the second electrode 660 may contact the upper surface of the upper contact plug 485 and an inner sidewall of the ferroelectric pattern 650.

The planarization process may include, e.g., a chemical mechanical polishing (CMP) process and/or an etch back process.

Referring back to FIGS. 1 to 5, a portion of the stack structure on the second region II of the first substrate 100 may be patterned such that the stack structure may have a staircase shape (see, for example, FIG. 5).

Accordingly, steps may be formed on the second region II of the first substrate 100, each of which may include the fourth insulation layer 600 and the plate electrode 610 stacked in the vertical direction. The steps may be disposed, e.g., in the first direction D1 as non-limiting examples. The steps may be disposed, e.g., in the second direction D2 in addition or as an alternative to being disposed in the first direction D1.

The semiconductor device illustrated in FIG. 6 may be implemented by forming eighth openings, each of which may extend in the first direction D1 through the stacked structure, spaced apart from each other in the second direction D2 on the first and second regions I and II of the first substrate 100, and forming a division pattern 670 in each of the eighth openings.

As described above, a plurality of gate structures 170 may be spaced apart from each other in the second direction D2 on the first substrate 100. Each of the gate structures 170 may extend in the first direction D1 through the upper portions of the first active patterns 105 and the isolation structure., A plurality of first bit line structures 355 spaced apart from each other in the first direction D1 may be formed, each of which may extend in the second direction D2 and may overlap central portions of the first active patterns 105, respectively. The bit line structures 355 disposed in the second direction D2 in a vertical direction, may be formed, and the contact plug structures contacting the upper surfaces of the edge portions of the first active patterns 105, respectively, may be formed.

The stack structure, which may include the fourth insulation layer 600 and the plate electrodes 610 alternately and repeatedly stacked in the vertical direction, may be formed on the contact plug structures and the first bit line structures 355. The seventh openings 720 extending through the stack structure to expose the upper surfaces of the contact plug structures, respectively, may be formed. The fifth recesses 630 may be formed by removing lateral portions of the plate electrodes 610, respectively, exposed by the seventh openings 720.

The first electrodes 640 may be formed in the fifth recesses 630, respectively, the ferroelectric patterns 650 may be formed on the sidewalls of the seventh openings 620, respectively, and the second electrodes 660 may be formed in remaining portions of the seventh openings 620, respectively, to contact the upper surfaces of the contact plug structures to form the capacitor including the second electrode 660, the ferroelectric pattern 650 and the first electrodes 640.

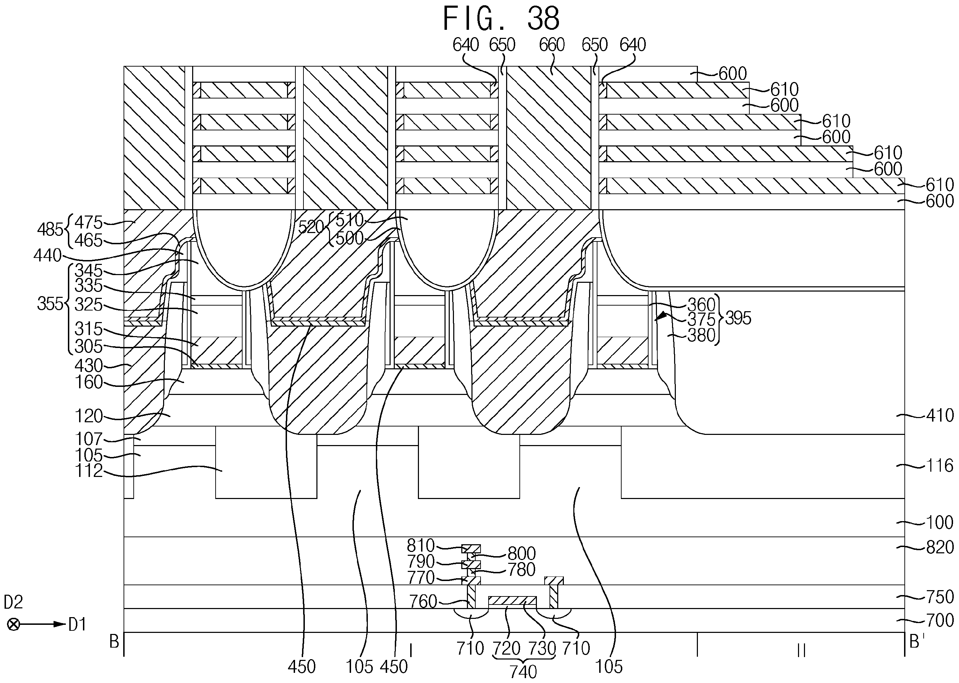

FIG. 38 is a cross-sectional view illustrating a semiconductor device in accordance with example embodiments, which may correspond to FIG. 5.

This semiconductor device may be substantially the same as or similar to that of FIGS. 1 to 6 except for some components, and thus repeated explanations are not repeated herein.

Referring to FIG. 38, a second substrate 700 may be formed under the first substrate 100, and a lower circuit pattern may be formed on the second substrate 700.

As shown in FIG. 38, the lower circuit pattern may include a lower transistor, lower contact plugs and lower wirings. The lower transistor may include a lower gate structure 740 on the second substrate 700, and second impurity regions 710 at upper portions, respectively, of the second substrate 700 adjacent to the lower gate structure 740. The lower gate structure 740 may include a lower gate insulation pattern 720 and a lower gate electrode 730 sequentially stacked in the vertical direction. The lower contact plugs may include a second lower contact plug 760 contacting an upper surface of the second impurity region 710.

The lower transistor and a sidewall of the second lower contact plug 760 may be covered by a first lower insulating interlayer layer 750 on the second substrate 700.

A second lower insulating interlayer layer 820 may be formed between the first lower insulating interlayer layer 750 and the first substrate 100. Some of the lower contact plugs and lower wirings may be formed in the second lower insulating interlayer layer 820. For example, a first lower contact plug 770, a third lower contact plug 780, a second lower wring 790, a fourth lower contact plug 800 and a third lower wiring 810 may be formed on the second lower contact plug 760.

The semiconductor device may have a cell over periphery (COP) structure, in which circuit patterns for applying electrical signals to memory cells are formed under the memory cells. As illustrated above, the capacitor may include the ferroelectric pattern 650, which may include a ferroelectric material instead of a paraelectric material, so that the cell transistor electrically connected to the capacitor may not necessarily include single crystal silicon having no crystal defects. Thus, the first substrate 100 including, e.g., polysilicon, may be formed on the lower circuit pattern, and the cell transistor may be formed on the first substrate 100.

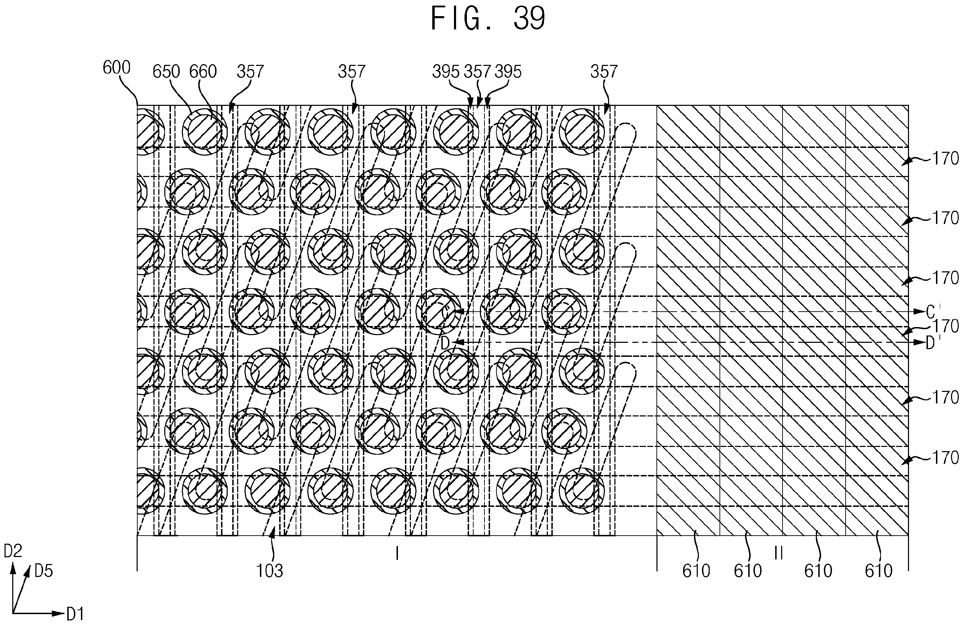

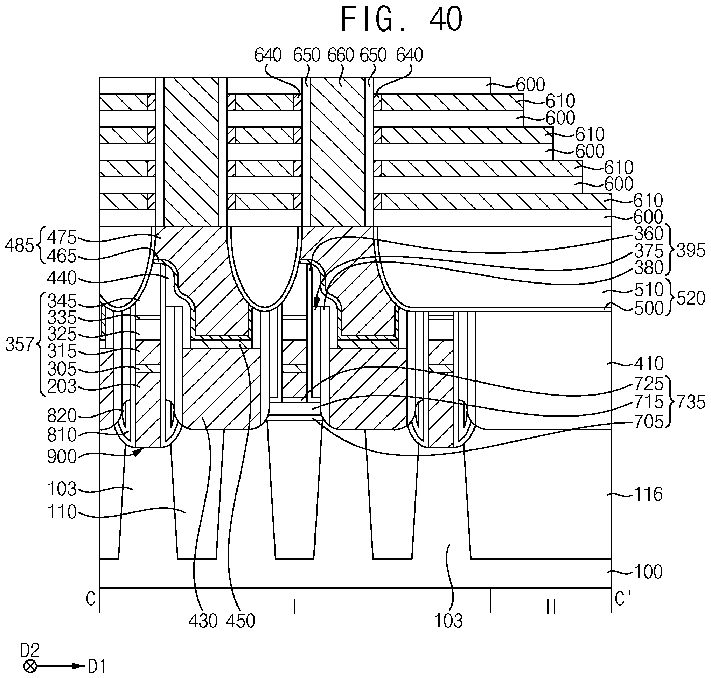

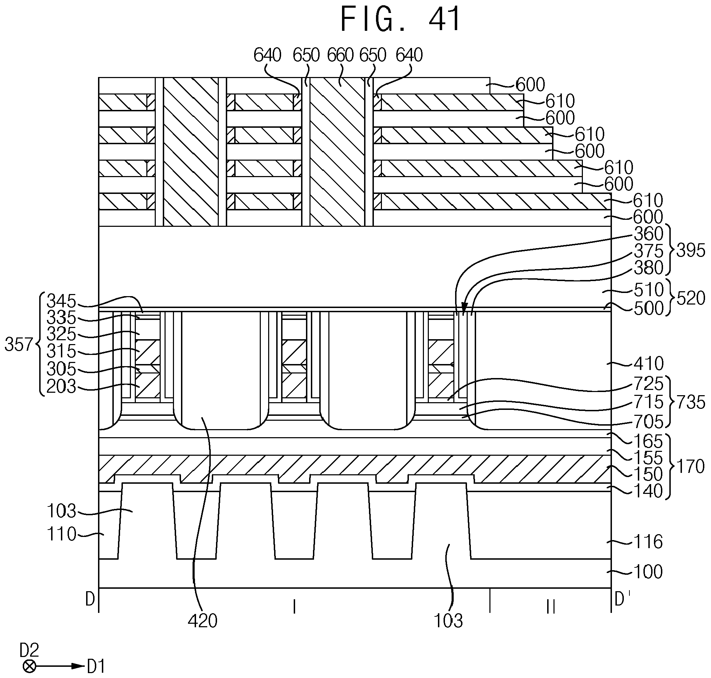

FIGS. 39 to 41 are a plan view and cross-sectional views illustrating a semiconductor device in accordance with example embodiments.

This semiconductor device may be substantially the same as, or similar to, that of FIGS. 1 to 6 except for some components. Thus, like reference numerals refer to like elements, and repeated explanations are not repeated herein.

Referring to FIGS. 39 to 41, the semiconductor device may include a second active pattern 103 on the first substrate 100, the gate structure 170, a second bit line structure 357, the contact plug structure, and the capacitor.

The semiconductor device may further include the isolation structure, the spacer structure 395, the fourth spacer 440, the second ohmic contact pattern 450, the first insulation pattern 410, the fence pattern 420, fourth and fifth insulation patterns 810 and 820, the second insulation pattern structure 520 and a third insulation pattern structure 735.

The second active pattern 103 may extend in a fifth direction D5, which may be substantially parallel to the upper surface of the first substrate 100 and may have an acute angle with respect to the first and second directions D1 and D2 on the first region I of the first substrate 100. A plurality of second active patterns 103 may be spaced apart from each other in the first and second directions D1 and D2. In example embodiments, the second active patterns 103 disposed in the second direction D2 may be aligned with each other, and the second active patterns 103 disposed in the first direction D1 may be arranged in a zigzag pattern.

A sidewall of the second active pattern 103 may be covered by the isolation structure. The isolation structure may include the fourth isolation pattern 110 on the first region I of the substrate 100 and the third isolation pattern 116 on the second region II of the substrate 100. Accordingly, the sidewall of the second active pattern 103 may be covered by the fourth isolation pattern 116.

A ninth opening 900, which may extend through the third insulation pattern structure 735 to expose the second active pattern 103, the fourth isolation pattern 116 and the first capping pattern 165 included in the gate structure 170, may be formed on the first region I of the substrate 100. An upper surface of a central portion in the fifth direction D5 of the second active pattern 103 may be exposed by the ninth opening 900.

In example embodiments, the ninth opening 900 may have a bottom greater (e.g. wider) than an upper surface of the second active pattern 103 exposed by the ninth opening 900. Accordingly, the ninth opening 900 may also expose an upper surface of the fourth isolation pattern 110 adjacent to the second active pattern 103. In addition, the ninth opening 900 may extend through an upper portion of the second active pattern 103 and upper portions of the fourth isolation pattern 110 and the first capping pattern 165 adjacent to the second active pattern 103, and thus the bottom of the ninth opening 900 may be lower than an upper surface of a portion of the second active pattern 103 on which the ninth opening 900 is not formed, that is, an upper surface of each of opposite edge portions of the second active pattern 103 in the third direction D3.

The second bit line structure 357 may include the adhesive pattern 305, the fourth conductive pattern 315, the second mask 325, the etch stop pattern 335 and the second capping pattern 345 sequentially stacked in the vertical direction on the ninth opening 900 or the third insulation pattern structure 735 The second bit line structure 357 may further include a fifth conductive pattern 203 under the adhesive pattern 305.

The fifth conductive pattern 203 may be disposed in the ninth opening 900 to contact the upper surface of the second active pattern 103, and may be disposed on an upper surface of the third insulation pattern structure 735 at an outside of the ninth opening 900. That is, the conductive filling pattern 200 may be disposed between the first bit line structure 355 and the first active pattern 105 in the semiconductor device described with reference to FIGS. 1 to 6, while the second bit line structure 357 including the fifth conductive pattern 203 may be disposed on the second active pattern 103 in the semiconductor device shown in FIGS. 39 to 41.

In an embodiment, the fifth conductive pattern 203 may include, e.g., polysilicon doped with impurities

In example embodiments, the second bit line structure 357 may extend in the second direction D2 on the first region I of the substrate 100, and a plurality of second bit line structures 357 may be spaced apart from each other in the first direction D1.

The fourth and fifth insulation patterns 810 and 820 may be disposed in the ninth opening 900, and may contact a lower sidewall of the second bit line structure 357. The fourth insulation pattern 810 may include an oxide, e.g., silicon oxide, and the fifth insulation pattern 820 may include an insulating nitride, e.g., silicon nitride.

The third insulation pattern structure 735 may be disposed under the second bit line structure 357 on the second active pattern 103 and the fourth isolation pattern 110, and may include sixth to eighth insulation patterns 705, 715, and 725 sequentially stacked in the vertical direction. The sixth and eighth insulation patterns 705 and 725 may include an oxide, e.g., silicon oxide, and the seventh insulation pattern 715 may include an insulating nitride, e.g., silicon nitride.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages thereof. Accordingly, all such modifications are intended to be included within the scope thereof as defined in the claims. In the claims, means-plus-function clauses are intended to cover the structures described herein as performing the recited function and not only structural equivalents but also equivalent structures. Therefore, it is to be understood that the foregoing is illustrative of various example embodiments and is not to be construed as limited to the specific example embodiments disclosed, and that modifications to the disclosed example embodiments, as well as other example embodiments, are intended to be included within the scope of the appended claims.

In view of the above, sample embodiments may provide a semiconductor device that has improved electrical characteristics.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device comprising:
a gate structure on a first substrate;
a bit line structure on the gate structure;
a contact plug structure on the first substrate, the contact plug being spaced apart from the bit line structure;
a stack structure on the bit line structure and the contact plug structure, the stack structure including insulation layers and plate electrodes alternately stacked in a vertical direction substantially perpendicular to an upper surface of the first substrate; and
a capacitor including:
a second electrode extending through the stack structure and contacting the contact plug structure;
a ferroelectric pattern on a sidewall of the second electrode; and
first electrodes on a sidewall of the ferroelectric pattern, the first electrodes contacting sidewalls of the plate electrodes, respectively, and being spaced apart from each other in the vertical direction.

2. The semiconductor device as claimed in claim 1, wherein the second electrode has a pillar shape extending in the vertical direction, and
wherein the ferroelectric pattern has a cylindrical shape surrounding the sidewall of the second electrode.

3. The semiconductor device as claimed in claim 2, wherein each of the first electrodes protrudes from the sidewall of the ferroelectric pattern in a horizontal direction substantially parallel to the upper surface of the first substrate.

4. The semiconductor device as claimed in any preceding claim, wherein each of the first electrodes does not contact sidewalls of the insulation layers.

5. The semiconductor device as claimed in any preceding claim, wherein each of the first electrodes has a sidewall having a convex shape toward the sidewall of a corresponding one of the plate electrodes in a horizontal direction substantially parallel to the upper surface of the first substrate.

6. The semiconductor device as claimed in any preceding claim, wherein each of the plate electrodes includes polysilicon doped with impurities or silicon-germanium doped with impurities, and each of the first and second electrodes includes a metal.

7. The semiconductor device as claimed in any preceding claim, wherein the capacitor is one of a plurality of capacitors spaced apart from each other in first and second directions that are substantially parallel to the upper surface of the first substrate and cross each other, and the plurality of capacitors extend through the stack structure.

8. The semiconductor device as claimed in any preceding claim, wherein:
the gate structure extends in a first direction substantially parallel to the upper surface of the first substrate, and is one of a plurality of gate structures spaced apart from each other in a second direction that is substantially parallel to the upper surface of the first substrate and intersects the first direction, and
the stack structure is one of a plurality of stack structures being spaced apart from each other in the second direction, each of the plurality of stack structures extending in the first direction.

9. The semiconductor device as claimed in claim 8, wherein the capacitor is one of a plurality of capacitors spaced apart from each other in the first direction, and each of the plurality of capacitors extends through a corresponding one of the plurality of stack structures.

10. The semiconductor device as claimed in any preceding claim, wherein:
the gate structure extends in a first direction substantially parallel to the upper surface of the first substrate, and
an edge portion of the stack structure in the first direction has a staircase shape.

11. The semiconductor device as claimed in any preceding claim, further comprising:
a second substrate under the first substrate; and
a lower circuit pattern between the second substrate and the first substrate.

12. A semiconductor device comprising:
a gate structure on a first substrate, the gate structure extending in a first direction substantially parallel to an upper surface of the first substrate;
a bit line structure on the gate structure;
a contact plug structure on the first substrate, the contact plug being spaced apart from the bit line structure;
a stack structure on the bit line structure and the contact plug structure, the stack structure including insulation layers and plate electrodes alternately stacked in a vertical direction substantially perpendicular to an upper surface of the first substrate; and
a capacitor including:
a second electrode extending through the stack structure and contacting the contact plug structure;
a ferroelectric pattern on a sidewall of the second electrode; and
a first electrode on a sidewall of the ferroelectric pattern, the first electrode contacting a sidewall of each of the plate electrodes,
wherein an edge portion of the stack structure in the first direction has a staircase shape.

13. The semiconductor device as claimed in claim 12, wherein the capacitor is one of a plurality of capacitors spaced apart from each other in the first direction and a second direction, which is substantially parallel to the upper surface of the first substrate and intersects the first direction, and the plurality of capacitors extending through the stack structure.

14. The semiconductor device as claimed in claim 12 or 13, wherein:
the gate structure is one of a plurality of gate structures spaced apart from each other in a second direction substantially parallel to the upper surface of the first substrate and intersecting the first direction, and
the stack structure is one of a plurality of stack structures spaced apart from each other in the second direction, each of the plurality of stack structures extending in the first direction.

15. A semiconductor device as claimed in claim 12, 13 or 14, wherein:
the second electrode has a pillar shape extending in the vertical direction, and
the ferroelectric pattern has a cylindrical shape surrounding the sidewall of the second electrode.
